# EUROPEAN PATENT APPLICATION

(11) **EP 4 523 808 A1**
(43) Date of publication of application: **19.03.2025**
(21) Application number: 24199189.2
(22) Date of filing: 09.09.2024
(51) Int. Cl.: B21B 1/40, C23C 14/04

(54) **METAL PLATE AND METHOD FOR MANUFACTURING THE SAME, AND METHOD FOR MANUFACTURING METAL MASK**

(30) Priority: 13.09.2023 JP 2023148746; 21.08.2024 JP 2024139778
(71) Applicant: Dai Nippon Printing Co., Ltd., Tokyo 162-8001 (JP)
(72) Inventor: NAKAMURA, Yusuke, Shinjuku-ku, Tokyo, 1628001 (JP); ISHIKAWA, Goro, Shinjuku-ku, Tokyo, 1628001 (JP); YANO, Hiroshi, Shinjuku-ku, Tokyo, 1628001 (JP); NUMATA, Hiroshi, Shinjuku-ku, Tokyo, 1628001 (JP); OKA, Hiroki, Shinjuku-ku, Tokyo, 1628001 (JP)
(74) Representative: Müller-Boré & Partner Patentanwälte PartG mbB

(57) **Abstract**

To provide a metal plate which is elongated and has a high homogeneity in a wider range, a method for manufacturing the metal plate, a metal mask obtained from the metal plate, and a method for manufacturing the metal mask. Provided is a metal plate which is elongated and is to be used for manufacturing a metal mask, in which when a differential expansion rate En in a unit length L0 in a longitudinal direction for an arbitrary position n in a width direction of the metal plate is measured at each of an arbitrary plurality of positions in the longitudinal direction, a difference in the differential expansion rate En in a central portion in the width direction is 9.0 × 10⁻⁶ or less at a plurality of the positions, and the central portion is a portion that occupies 80% in the width direction of the metal plate excluding both side portions that occupy 10% in the width direction.

## Description

### BACKGROUND OF THE INVENTION

### Field of the Invention

The present invention relates to a metal plate, a method for manufacturing the metal plate, and a method for manufacturing a metal mask.

### Description of the Related Art

In recent years, display devices used in portable devices such as smartphones and tablet PCs have been required to be high-definition, for example, required to have a pixel density of 500 ppi or more. A demand for portable devices to be compatible with ultra-high definition (UHD) has also been increased. In this case, display devices preferably have a pixel density of 800 ppi or more, for example.

Among display devices, organic EL display devices are receiving attention because of their good responsiveness, low power consumption, and high contrast. Known as a method for forming pixels of an organic EL display device is a method for forming pixels in a desired pattern using a metal mask in which through-holes arrayed in the desired pattern have been formed. Specifically, the metal mask is first brought into close contact with a substrate for an organic EL display device. Next, the metal mask and the substrate in close contact with each other are input together to a vapor deposition device, and a vapor deposition step of vapor-depositing an organic material on the substrate is performed. Pixels containing the organic material can thereby be formed on the substrate in a pattern corresponding to the pattern of through-holes in the metal mask.

Known as a method for manufacturing a metal mask is a method for forming through-holes in a metal plate by etching through use of the photolithography technology. For example, a first resist pattern is first formed on a first surface of a metal plate through exposure and development treatment, and a second resist pattern is formed on a second surface of the metal plate through exposure and development treatment. Next, a region of the first surface of the metal plate which is not covered by the first resist pattern is etched to form a first recess in the first surface of the metal plate. Thereafter, a region of the second surface of the metal plate which is not covered by the second resist pattern is etched to form a second recess in the second surface of the metal plate. On this occasion, etching is performed such that the first recess and the second recess communicate with each other. Through-holes extending through the metal plate can thereby be formed (see, for example, Japanese Patent Laid-Open No. 2014-148743).

A metal plate for producing a metal mask is produced by rolling a base material made of an iron alloy containing nickel, for example. Through-holes in the metal mask obtained are improved in dimensional accuracy as the metal plate is rolled more thinly. However, on the other hand, a wavy shape appears in no small part in the metal plate due to rolling. Appearance of such a wavy shape might degrade the dimensional accuracy of the through-holes formed in the metal plate.

Therefore, it is important to evaluate the wavy shape of the metal plate from a viewpoint of quality assurance of the metal plate. On the other hand, the metal plate obtained by rolling is very elongated. Therefore, from the viewpoint of quality assurance of the overall metal plate, it is preferable to evaluate the wavy shape of the metal plate in a wider range.

However, a conventional measurement device for evaluating the wavy shape of a metal plate is to measure, in a sheet form, a measurement sample cut out from the metal plate. Therefore, it is difficult to evaluate the wavy shape of the metal plate in a wide range. Moreover, an elongated metal plate have some locations where the wavy shape is hardly seen and other locations where the wavy shape is seen. Consequently, even if a result that the metal plate has a less wavy shape is obtained by sheet-form measurement, it is a partial result and does not indicate that the overall elongated metal plate has a less wavy shape.

In a case of performing the etching process through use of the photolithography technology for a roll of the metal plate, cutting out a measurement sample from an intermediate portion of the roll of the metal plate disconnects the roll itself, which significantly affects the etching process. Therefore, in this case, a measurement sample is cut out from a leading end of the roll of the metal plate. Consequently, it is difficult with the conventional sheet-form measurement device to evaluate the wavy shape in a wide range including the intermediate portion of the roll of the metal plate.

The present invention has been made in view of the above-described problems and has an object to provide a metal plate which is elongated and has a high homogeneity in a wider range, a method for manufacturing the metal plate, and a method for manufacturing a metal mask through use of the metal plate.

### SUMMARY OF THE INVENTION

A metal plate according to one embodiment of the present disclosure is a metal plate which is elongated and is to be used for manufacturing a metal mask, in which
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

A metal plate according to one embodiment of the present disclosure is a metal plate which is elongated and is to be used for manufacturing a metal mask, in which
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

A method for manufacturing a metal plate according to one embodiment of the present disclosure is a method for manufacturing a metal plate which is elongated and is to be used for manufacturing a metal mask, including
a rolling step of rolling a base material to obtain the metal plate which is elongated, in which
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En at a plurality of the positions is 9.0 × 10⁻⁶ or less.

A method for manufacturing a metal plate according to one embodiment of the present disclosure is a method for manufacturing a metal plate which is elongated and is to be used for manufacturing a metal mask, including
a rolling step of rolling a base material to obtain the metal plate which is elongated, in which
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En at a plurality of the positions is 9.0 × 10⁻⁶ or less, and
the plurality of the positions include both end portions in the longitudinal direction of the metal plate and a portion that internally divides the metal plate in the longitudinal direction into one or more portions.

A method for manufacturing a metal mask according to one embodiment of the present disclosure includes:
a rolling step of rolling a base material to prepare a metal plate which is elongated; and
an etching step of etching the metal plate to form the metal mask, in which
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En at a plurality of the positions is 9.0 × 10⁻⁶ or less.

A method for manufacturing a metal mask according to one embodiment of the present disclosure includes:
a rolling step of rolling a base material to prepare a metal plate which is elongated; and
an etching step of etching the metal plate to form the metal mask, in which
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En at a plurality of the positions is 9.0 × 10⁻⁶ or less, and
the plurality of the positions include both end portions in the longitudinal direction of the metal plate and a portion that internally divides the metal plate in the longitudinal direction into one or more portions.

### Advantageous Effects of the Invention

According to the present invention, a metal plate which is elongated and has a high homogeneity in a wider range, a method for manufacturing the metal plate, and a method for manufacturing a metal mask through use of the metal plate can be provided.

### BRIEF DESCRIPTION OF THE DRAWINGS

FIG. 1A is an outlined perspective view representing an example of an elongated metal plate of the present disclosure;
FIG. 1B is an enlarged view of a region Sk of the elongated metal plate in FIG. 1A;
FIG. 1C is a cross-sectional view of the metal plate in FIG. 1B taken in a longitudinal direction;
FIG. 1D is a top view when the metal plate in FIG. 1B is seen in plan view;
FIG. 1E is a conceptual diagram showing a relationship among lengths obtained when a surface of the metal plate in FIG. 1D is measured in the longitudinal direction at respective positions n in the width direction;
FIG. 1F is a graph for describing a differential expansion rate En at each of the positions n in the width direction of the metal plate in FIG. 1B;
FIG. 1G is a graph representing overlapped differential expansion rate profiles of the elongated metal plate at an arbitrary plurality of positions in the longitudinal direction;
FIG. 1H is an outlined perspective view representing another example of the elongated metal plate of the present disclosure;
FIG. 2A is a partially enlarged view showing an example of an elongated metal plate having a wavy shape;
FIG. 2B is a partially enlarged view of an exposure step for the elongated metal plate;
FIG. 2C is a partially enlarged view of an etching step for the elongated metal plate;
FIG. 2D is a top view of a metal mask in which distortion caused by the wavy shape is reflected;
FIG. 2E is a top view of a state where tension in the longitudinal direction is applied to the metal mask;
FIG. 3A is an outlined perspective view representing an example of a measurement device for the metal plate of the present disclosure;
FIG. 3B is an outlined cross-sectional view showing an aspect of first to third steps;
FIG. 3C is a flowchart representing an aspect of a method for measuring the metal plate;
FIG. 4A is an outlined cross-sectional view showing an aspect of a rolling step;
FIG. 4B is an outlined cross-sectional view showing an aspect of an annealing step;
FIG. 5A is an outlined plan view showing a metal mask according to an embodiment of the present disclosure;
FIG. 5B is an outlined perspective view showing an aspect when a perforated region is seen from a second surface side;
FIG. 5C is a cross-sectional view of a cross-section I-I shown in FIG. 5B;
FIG. 5D is an outlined perspective view showing an aspect when the perforated region is seen from the second surface side;
FIG. 6A is an outlined schematic view for describing an example of a method for manufacturing a metal mask;
FIG. 6B is a diagram showing an example of a step of forming a resist film on a metal plate;
FIG. 6C is a diagram showing an example of a step of patterning the resist film;
FIG. 6D is a diagram showing an example of a first surface etching step;
FIG. 6E is a diagram showing an example of a second surface etching step;
FIG. 7 is a diagram showing a metal mask device according to an embodiment of the present disclosure; and
FIG. 8 is a cross-sectional view showing a vapor deposition device according to an embodiment of the present disclosure.

### DETAILED DESCRIPTION OF THE PREFERRED EMBODIMENT

Hereinafter, an embodiment of the present disclosure will be described with reference to the drawings. Note that in the drawings attached to the present specification, for convenience of ease of depiction and understanding, scale ratios, longitudinal and lateral dimensional ratios, and the like are exaggerated as appropriate by changing them from actual ones in some cases.

In the present specification and/or the present drawings, interpretation will be made as indicated below unless particularly described.

Terms that mean a substance on which a certain component is based may not be distinguished from each other only based on different names. For example, terms such as a "substrate", a "base material", a "plate", a "sheet", and a "film" are relevant to the above description.

Terms and/or numerals that mean shapes and/or geometric conditions are not necessarily limited to their strict definitions, but may be construed to include a range to a degree that similar functions may be expected. For example, terms such as "parallel" and/or "orthogonal" are relevant to the above-described terms. Values such as "values of length" and/or "values of angle" are relevant to the above-described numerals.

In some cases where a component is expressed as being "on", "under", "on an upper side of", "on a lower side of", "above", or "below" another component, the cases may include an aspect in which the component is in direct contact with the other component, and an aspect in which a different component is included between the component and the other component. In other words, the aspect in which a different component is included between the component and the other component may be expressed as the component and the other component being in indirect contact with each other. The expression "on", "upper side", or "above" can be exchanged to the expression "under", "lower side", or "below". In other words, an up-down direction may be reversed.

Identical portions and/or portions that have a similar function are designated by identical reference characters or like reference characters, and repeated description is omitted in some cases. The ratio of dimensions in the drawings differs from an actual ratio in some cases. Illustration of some components of an embodiment is omitted in the drawings in some cases.

One or more embodiments and one or more modifications may be combined within a range where no contradiction occurs. One or more embodiments may be combined within a range where no contradiction occurs. One or more modifications may be combined within a range where no contradiction occurs.

In a case where a plurality of steps are disclosed in relation to a method such as a manufacturing method, another undisclosed step may be performed between the disclosed steps. The order of the steps is not limited within a range where no contradiction occurs.

A numeral range expressed by the word "to" includes numerals placed in front of and behind the word "to". For example, a numeral range expressed as "34 to 38 mass %" is identical to a numeral range expressed as "34 mass % or more and 38 mass % or less".

A numeral range of a numeral described in the present disclosure may be defined by combining an arbitrary one of a plurality of upper-limit candidate values and an arbitrary one of a plurality of lower-limit candidate values. Besides, any two of the plurality of upper-limit candidate values may be combined to define the numeral range, or any two of the plurality of lower-limit candidate values may be combined to define the numeral range without particular mention.

One embodiment of the present disclosure will be described in the following paragraphs. One embodiment of the present disclosure is an example of embodiments of the present disclosure. The present disclosure is not construed as being limited only to the one embodiment of the present disclosure.

The metal plate of the present disclosure is a metal plate which is elongated and is to be used for manufacturing a metal mask. The metal mask can be used for various applications. Although not particularly limited, the metal mask can be used as, for example, a metal mask to be used for patterning an organic material on a substrate in a desired pattern in manufacturing of an organic EL display device. The metal mask is also called a vapor deposition mask. The metal mask of the present disclosure enables patterning at a high pixel density. Organic EL display devices that can be manufactured include not only displays of a smartphone, a television, and the like, but also devices for displaying or projecting an image or video for expressing virtual reality (VR) or augmented reality (AR).

A first aspect of the present disclosure is a metal plate which is elongated and is to be used for manufacturing a metal mask, in which
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

A second aspect of the present disclosure is a metal plate which is elongated and is to be used for manufacturing a metal mask, in which
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

A third aspect of the present disclosure is the metal plate of the first aspect or the second aspect described above, in which a maximum value of the differential expansion rate En in the central portion in the width direction is 2.5 × 10⁻⁵ or less at the plurality of the positions.

A fourth aspect of the present disclosure is the metal plate of any one of the first to third aspects described above, in which the metal plate has a roll shape.

A fifth aspect of the present disclosure is the metal plate of any one of the first to fourth aspects described above, in which the metal plate has a length of 50 to 800 m in the longitudinal direction.

A sixth aspect of the present disclosure is the metal plate of any one of the first to fifth aspects described above, in which the metal plate has a thickness of 50 µm or less.

A seventh aspect of the present disclosure is a method for manufacturing a metal plate which is elongated and is to be used for manufacturing a metal mask, including
a rolling step of rolling a base material to obtain the metal plate which is elongated, in which
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

An eighth aspect of the present disclosure is a method for manufacturing a metal plate which is elongated and is to be used for manufacturing a metal mask, including
a rolling step of rolling a base material to obtain the metal plate which is elongated, in which
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

A ninth aspect of the present disclosure is a method for manufacturing a metal mask, including:
a rolling step of rolling a base material to prepare a metal plate which is elongated; and
an etching step of etching the metal plate to form the metal mask, in which
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

A tenth aspect of the present disclosure is a method for manufacturing a metal mask, including:
a rolling step of rolling a base material to prepare a metal plate which is elongated; and
an etching step of etching the metal plate to form the metal mask, in which
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

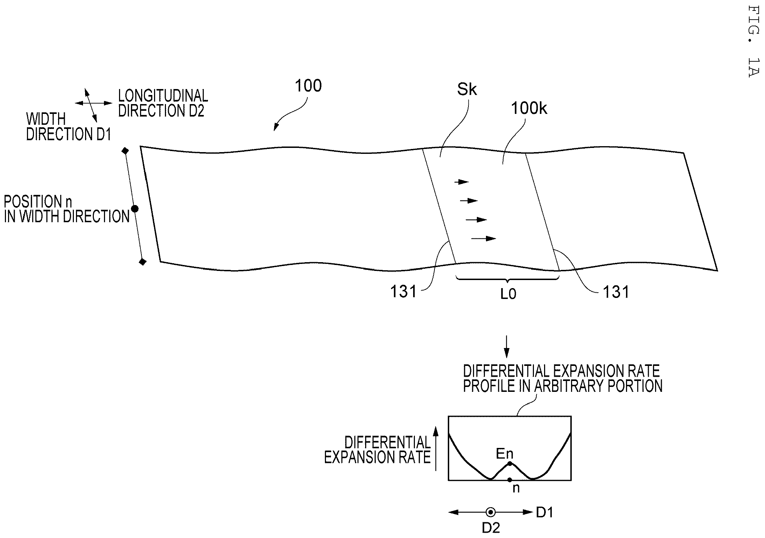

FIG. 1A shows a perspective view showing an example of an elongated metal plate 100 of an aspect of the present disclosure. Note that although FIG. 1A shows an aspect in which the elongated metal plate 100 is extended, the elongated metal plate 100 may have a form wound into a roll shape.

A length of the elongated metal plate 100 in a width direction D1 preferably may be 200 mm or more, may be 300 mm or more, may be 350 mm or more, may be 400 mm or more, may be 450 mm or more, or may be 500 mm or more. The length of the elongated metal plate 100 in the width direction D1 preferably may be 800 mm or less, may be 750 mm or less, may be 700 mm or less, may be 650 mm or less, may be 600 mm or less, or may be 550 mm or less. The length of the elongated metal plate 100 in the width direction D1 preferably may be 300 mm to 800 mm, may be 350 mm to 750 mm, may be 400 mm to 700 mm, or may be 450 mm to 650 mm.

A total length of the elongated metal plate 100 in a longitudinal direction D2 preferably may be 50 m or more, may be 100 m or more, may be 150 m or more, may be 200 m or more, may be 300 m or more, may be 400 m or more, or may be 500 m or more. The total length of the elongated metal plate 100 in the longitudinal direction D2 preferably may be 1200 m or less, may be 1000 m or less, may be 800 m or less, may be 700 m or less, or may be 600 m or less. The total length of the elongated metal plate 100 in the longitudinal direction D2 preferably may be 50 m to 1200 m, may be 50 m to 1000 m, may be 50 m to 800 m, or may be 100 m to 800 m.

A thickness of the elongated metal plate 100 preferably may be 100 µm or less, may be 50 µm or less, may be 45 µm or less, may be 40 µm or less, may be 35 µm or less, may be 30 µm or less, may be 25 µm or less, or may be 20 µm or less. The thickness of the elongated metal plate 100 preferably may be 2.5 µm or more, may be 5 µm or more, may be 10 µm or more, or may be 15 µm or more. The thickness of the elongated metal plate 100 preferably is 2.5 to 100 µm, 5 to 50 µm, or 10 to 40 µm. Reducing the thickness enables a perforated region 22 of the metal mask 20 which will be described later to be configured more thinly, which leads to a tendency that a vapor deposition material 98 can be prevented from adhering to a second wall surface 36 of the second recess 35 in a vapor deposition step. Increasing the thickness leads to a tendency that the strength of the metal mask 20 is further improved. This leads to a tendency that the perforated region 22 can be prevented from being deformed or broken, for example.

Note that when reducing the thickness, increasing a rolling rate in the rolling step in the method for manufacturing the elongated metal plate 100 is considered. However, when the rolling rate is simply increased, the degree of non-uniformity of rolling-based deformation is likely to be increased, so that a wavy shape which will be described later is likely to occur.

A material constituting the elongated metal plate 100 can include, for example, but is not particularly limited to, an iron alloy containing nickel, an iron alloy containing chromium, such as stainless steel, nickel, a nickel-cobalt alloy, or the like.

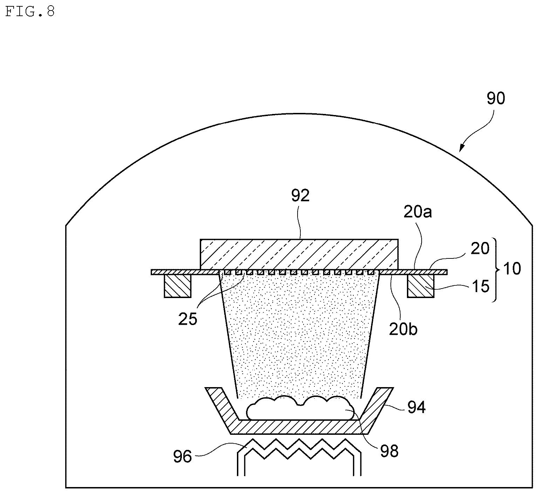

Among them, an iron alloy containing nickel is preferable. Through use of an iron alloy containing nickel, the thermal expansion coefficient of the metal mask 20 to be obtained from the elongated metal plate 100 can have a value equivalent to the thermal expansion coefficient of a frame 15 and the thermal expansion coefficient of a substrate 92 (see FIG. 8). This can prevent an occurrence of misalignment resulting from differences in dimensional change among the metal mask 20, the frame 15, and the substrate 92 during vapor deposition treatment. It is therefore possible to prevent degradation in dimensional accuracy and positional accuracy of the vapor deposition material 98 adhering to the substrate 92 that would result from the misalignment.

The iron alloy containing nickel can include, for example, but is not particularly limited to, an iron alloy containing 30 mass % or more and 54 mass % or less nickel, such as a super-invar material further containing cobalt in addition to 30 mass % or more and 34 mass % or less nickel, an invar material containing 34 mass % or more and 38 mass % or less nickel, or a low thermal expansion Fe-Ni-based plating alloy containing 48 mass % or more and 54 mass % or less nickel.

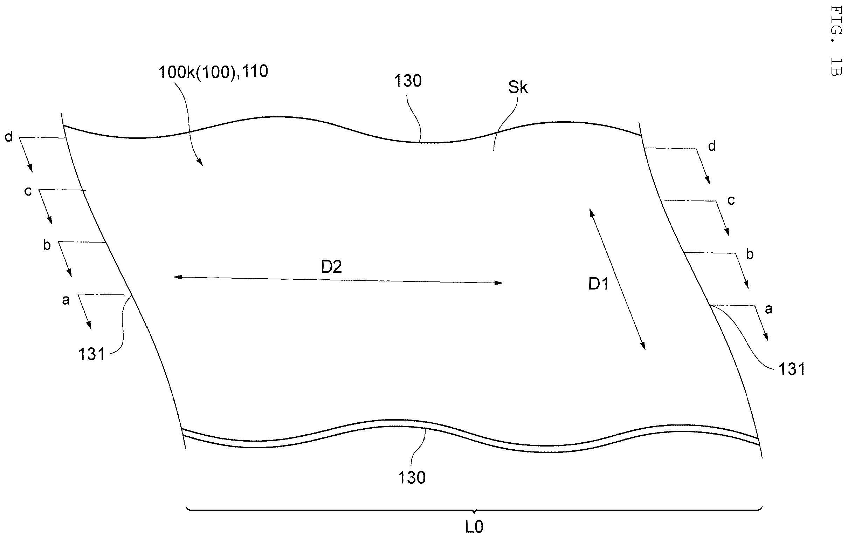

FIG. 1B is an enlarged view of a region Sk in FIG. 1A. The region Sk is any location of the elongated metal plate 100 in the longitudinal direction D2. The region Sk is a region enclosed by two sides 131 parallel to the width direction D1 of the elongated metal plate 100 and two side edges 130. An interval between the two sides 131 is the unit length L0 in the longitudinal direction D2. Hereinafter, a portion of the elongated metal plate 100 corresponding to the region Sk will also be called a "metal plate 100k".

As shown in FIG. 1B, the elongated metal plate 100 at least partially has a wavy shape. The wavy shape results from a fact that the length of the metal plate 100k in the longitudinal direction D2 in the region Sk differs depending on the position in the width direction D1. The degree of the wavy shape can be evaluated by the differential expansion rate En. The "region Sk" indicates a range in which the differential expansion rate En of the present disclosure is measured at one time. The "unit length L0" indicates a length in the longitudinal direction D2 when the differential expansion rate En of the present disclosure is measured.

Note that from a viewpoint of evaluating an influence of the differential expansion rate En on the metal mask 20, the unit length L0 may be a length equivalent to the length of the metal mask 20 in the longitudinal direction. In the case where the unit length L0 is the same as the length of the metal mask 20 in the longitudinal direction, it preferably may be 1000 mm or more and 1800 mm or less, or, for example, may be 980 mm, 1280 mm, or 1648 mm. Note that the unit length L0 refers to a length of the metal plate 100k when seen in plan view.

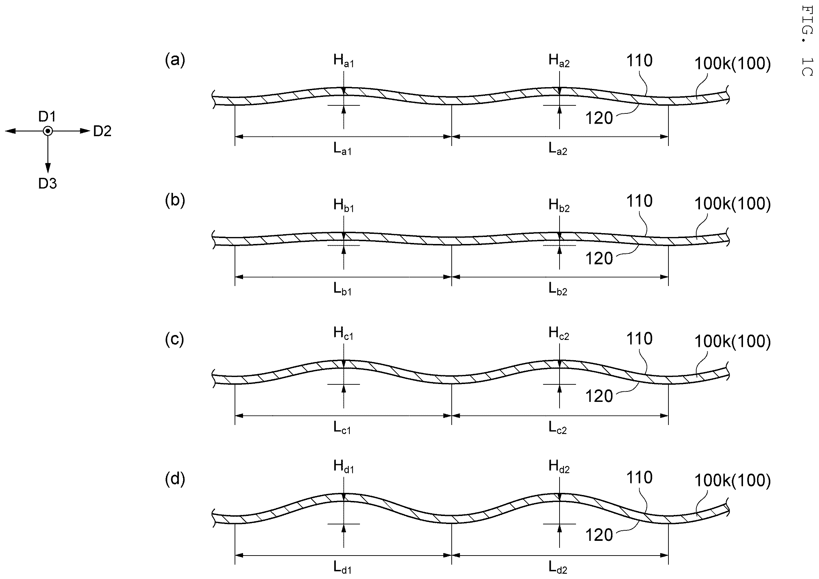

FIG. 1C is a cross-sectional view of the metal plate 100k in FIG. 1B taken in the longitudinal direction D2. Respective cross-sectional views (a) to (d) in FIG. 1C are cross-sectional views taken along lines a-a, b-b, c-c, and d-d in FIG. 1B. All of the lines a-a, b-b, c-c, and d-d are lines parallel to the longitudinal direction D2.

In the aspect shown in FIG. 1C, the cross-sectional view (d) passing through a place close to the side edge 130 is the waviest. As is apparent from a comparison among the cross-sectional views (b) to (d), the cross-sectional views gradually become less wavy from the side edge 130 in the width direction D1 toward the center. As is apparent from a comparison between the cross-sectional views (b) and (a), the cross-sectional view (a) is slightly wavier.

In the present disclosure, the differential expansion rate En in the unit length L0 in the longitudinal direction D2 for the arbitrary position n in the width direction D1 of the metal plate 100k is measured. In other words, the differential expansion rate En is measured from a cross-sectional view taken at the arbitrary position n in the width direction D1, such as the cross-sectional views (a) to (d).

In FIG. 1C(a) to (d), for example, two waves represented by periods La to Ld at heights Ha to Hd are shown in the unit length L0 as an illustration. The number of waves per unit length L0 is not particularly limited and may be one or may be three or more.

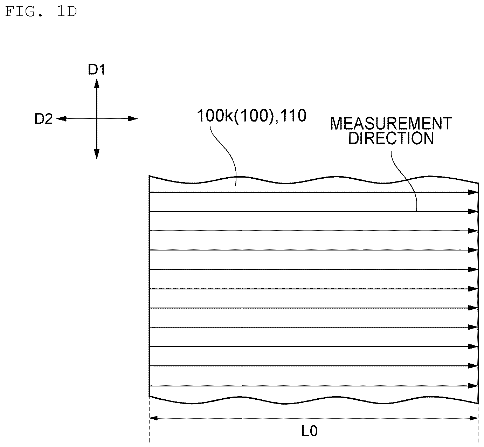

FIG. 1D is a top view of the metal plate 100k in FIG. 1B when seen in plan view. When the top view is seen, the metal plate 100k in the unit length L0 actually has a wavy shape as shown by the cross-sectional views (a) to (d) in FIG. 1C. Therefore, the surface length of the metal plate 100k along the wavy shape is longer than the unit length L0.

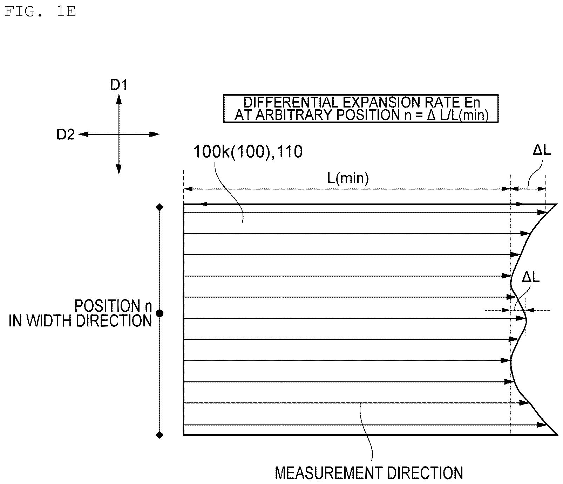

FIG. 1E is a conceptual diagram showing a relationship among lengths obtained when a first surface 110 of the metal plate 100k in FIG. 1D is measured in the longitudinal direction D2 at the respective positions n in the width direction. FIG. 1E shows the lengths obtained when a surface length Ln of the metal plate 100k along the wavy shape is measured in the longitudinal direction D2 at the positions n in the width direction. The surface length Ln of the metal plate 100k along the wavy shape can be thought of as the length of the metal plate 100k in the longitudinal direction D2 to be obtained when the metal plate 100k is pulled in the longitudinal direction D2 to flatten the waves.

Herein, the "differential expansion rate" in the present disclosure is a value calculated from a minimum value L(min) of Ln and a difference ΔLn between L(min) and Ln by the following equation: Differential expansion rate En at position n = ΔLn/L(min)

For example, a sample of the metal plate 100k which is 500 mm in the width direction and 1280 mm (the unit length L0) in the longitudinal direction is assumed. When a surface of this sample is measured in the longitudinal direction D2, the minimum value L(min) shall be 1280.1352 mm at a location of +75 mm from the center. At this time, L shall be 1280.1612 mm at a location of +0 mm from the center, and ΔL shall be 26.0 µm. Based on this premise, the differential expansion rate E at the location of +0 mm from the center is calculated as 2.0 × 10⁻⁵ (= 26.0 µm/1281.1352 mm).

Note that the above-described example is a numerical illustration for describing the differential expansion rate in the present disclosure and has no relation with examples of the metal plate and the like of the present disclosure.

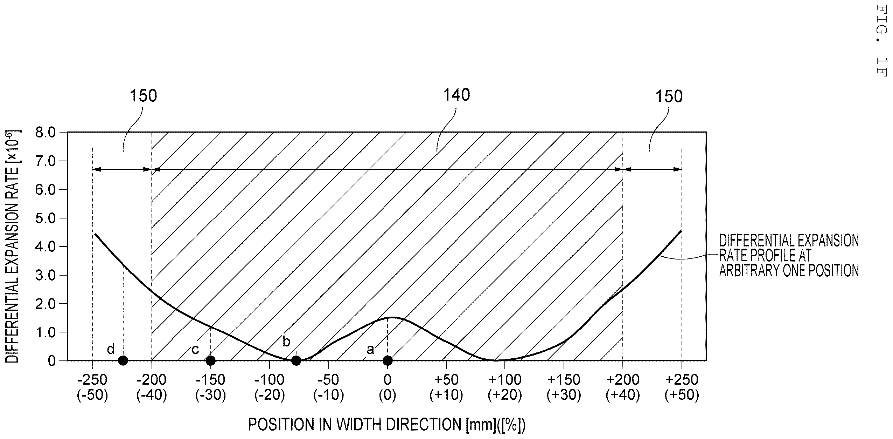

FIG. 1F shows a graph representing the differential expansion rate En at each of the positions n in the width direction D1 of the metal plate 100k. In FIG. 1F, the horizontal axis indicates the positions in the width direction D1 of the metal plate 100k. FIG. 1F shows the metal plate 100k having a width of 500 mm by coordinates of ±250 mm (±50%) to the side edges 130 on the horizontal axis on which a central position in the width direction D1 is located at 0 mm (0%). Points a to d in FIG. 1F indicate the respective positions of the lines a-a, b-b, c-c, and d-d in the width direction D1, respectively. Changes in the differential expansion rate En in the width direction D1 in the metal plate 100k can be depicted by FIG. 1F. A graph showing changes in the differential expansion rate En in the width direction D1 in the metal plate 100k as shown in FIG. 1F or data indicating the changes is also called a "differential expansion rate profile" in the present disclosure.

Note that the point a is positioned at the center (0 mm [0%]) of the metal plate 100k in the width direction D1. The point d is positioned (-225 mm [-45%]) on the side edge 130 side of the metal plate 100k in the width direction D1. The points b and c are positioned respectively at internally dividing points (-75 mm [-15%] and -150 mm [-30%]) which equally divide a range between the point a and the point d.

In the present disclosure, a range of ±40% from the central position in the width direction D1 is referred to as a central portion 140, and ranges from ends of the central portion 140 to the side edges 130 are referred to as side portions 150. In other words, the central portion 140 is a portion excluding both the side portions 150 that occupy 10% in the width direction D1 of the elongated metal plate 100, and the central portion 140 is a portion that occupies 80% in the width direction D1. The vertical axis indicates the differential expansion rate En at the arbitrary position n in the width direction D1 of the metal plate 100k.

The differential expansion rate profile has a tendency that a local maximum value of the differential expansion rate En appears (the point a) in the vicinity of the central portion 140 of the elongated metal plate 100 in the width direction as shown in FIG. 1F. A local minimum value of the differential expansion rate En appears (the point b) at a position slightly away from the central portion 140 of the elongated metal plate 100 in the width direction to the side edge 130. The differential expansion rate En increases (the point c) from the point b toward the side edge 130 in the width direction D1, and the value of the differential expansion rate En is maximized (the point d) at the side edge 130 in the width direction D1. However, the shape of the differential expansion rate profile is not limited to this.

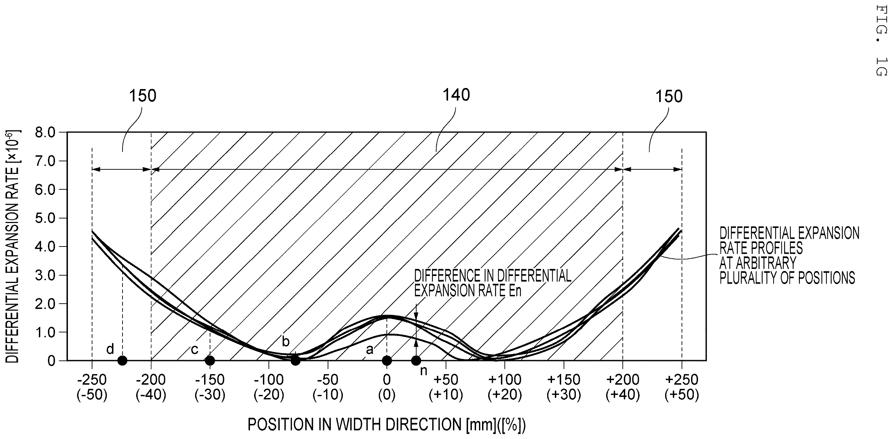

FIG. 1G is a graph representing differential expansion rate profiles as shown in FIG. 1F measured at an arbitrary plurality of positions in the longitudinal direction D2, the differential expansion rate profiles measured at the plurality of positions being overlapped on one another. As shown in FIG. 1G, the differential expansion rate profiles measured at the plurality of positions each have a slightly different shape in some cases.

Note that the width of 500 mm of the metal plate 100k in FIG. 1F and FIG. 1G is merely an illustration, and the metal plate 100k may have a larger width or a smaller width.

If the differential expansion rate profiles of the elongated metal plate 100 differ in accordance with positions in the longitudinal direction D2, the metal mask 20 obtained when the metal mask 20 is cut out at each position of the elongated metal plate 100 varies in shape. Therefore, the differential expansion rate profiles in accordance with positions in the longitudinal direction D2 preferably are the same or have a small difference.

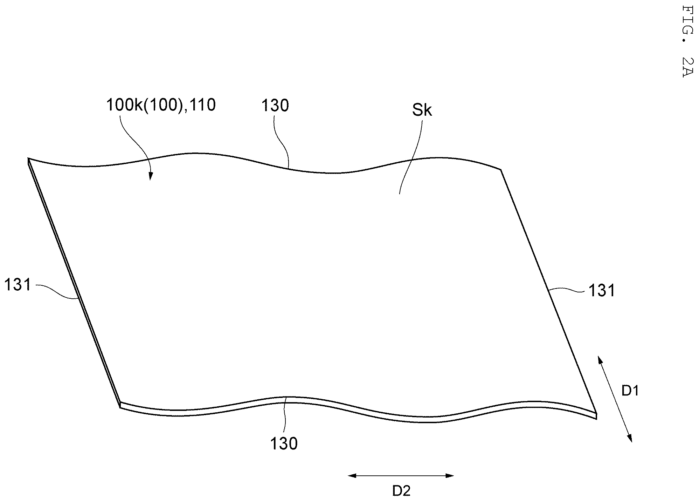

Hereinafter, this point will be described in more detail with reference to FIG. 2A to FIG. 2E. FIG. 2A to FIG. 2E partially show steps of manufacturing the metal mask device 10 from the elongated metal plate 100. FIG. 2A to FIG. 2C are enlarged views of an arbitrary region of the elongated metal plate 100.

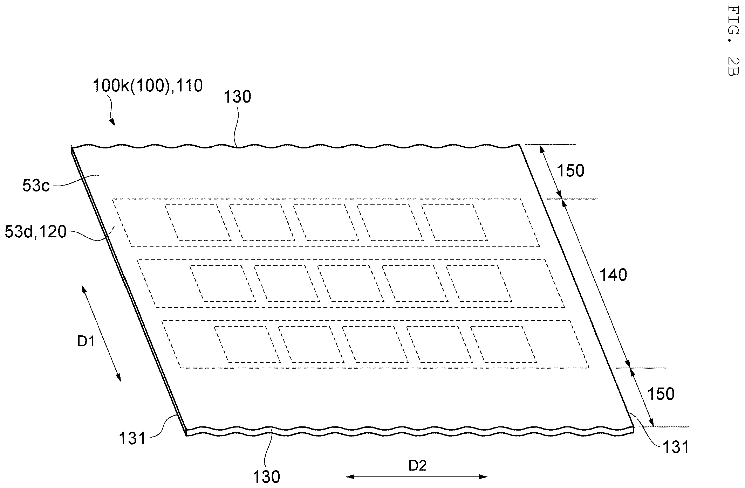

First, the elongated metal plate 100 at least partially having a wavy shape as shown in FIG. 2A is assumed. FIG. 2B shows an outlined view of a step of forming the first resist pattern 53c on the first surface 110 of the elongated metal plate 100 and the second resist pattern 53d on the second surface 120 and performing exposure. In the step, an exposure mask is brought into close contact with the first resist pattern 53c and the second resist pattern 53d on the elongated metal plate 100 through vacuum adsorption or the like. Therefore, the wavy shape of the elongated metal plate 100 is compressed, and the elongated metal plate 100 is brought into a substantially flat state. In this flattened state, a predetermined resist pattern is formed so as to define outer shapes of the metal masks 20 in portions indicated by broken lines in FIG. 2B.

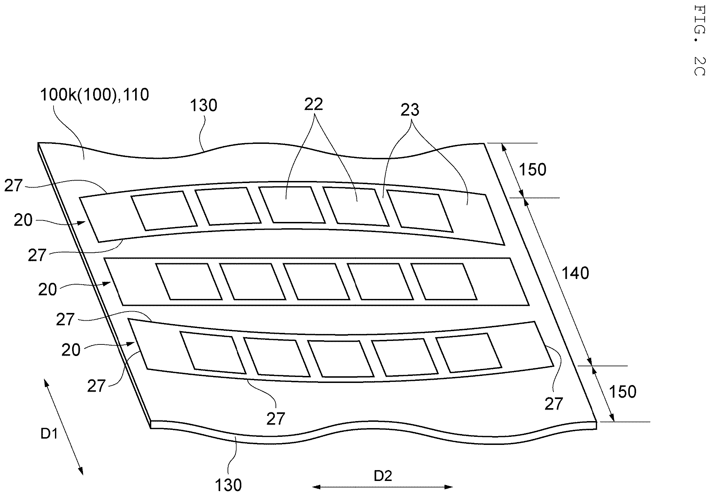

Next, FIG. 2C shows an outlined perspective view of an etching step through the resist pattern. In the step, the exposure mask has been removed from the elongated metal plate 100, and the wavy shape is restored to the degree shown in FIG. 2A. Therefore, the outer shapes 27 of the metal masks 20 obtained by the etching step also have shapes reflecting the wavy shape as shown in FIG. 2C. Specifically, the outer shapes 27 of the metal masks 20 are likely to be curved to the sides having a wavier shape (the sides closer to the side edges 130).

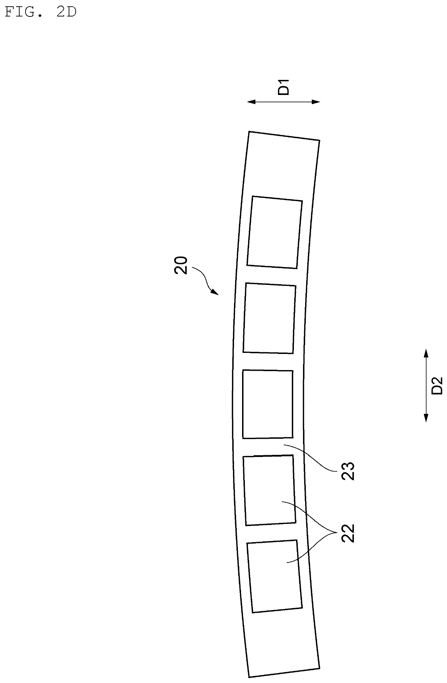

When etching is performed in the state where the wavy shape has been restored as shown in FIG. 2C, the metal mask 20 in which distortion caused by the wavy shape is reflected is obtained as shown in FIG. 2D. Specifically, the metal mask 20 is likely to be curved to the side having a wavier shape (the side closer to the side edge 130).

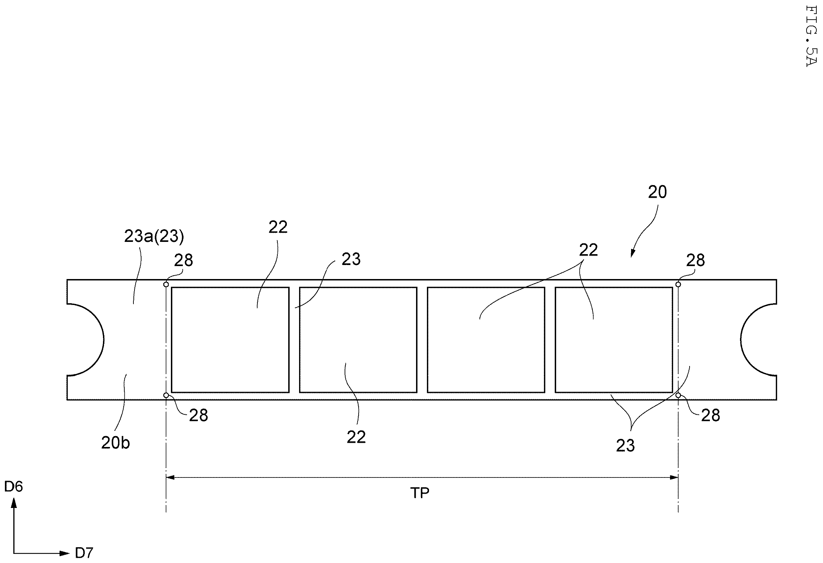

When the distortion caused by the wavy shape is reflected in this manner, the metal mask 20 obtained varies in size. The variation can be evaluated by total pitch marks 28 as shown in FIG. 5A which will be described later. Such variation is a cause of degrading the positional accuracy of the through-holes 25. Therefore, it is preferable that variation in size of the metal mask 20 obtained should be prevented.

Note that since the side portions 150 are places in which the differential expansion rate En is comparatively high as shown in FIG. 1F, the metal mask 20 may be formed in the central portion 140 as shown in FIG. 2B and FIG. 2C.

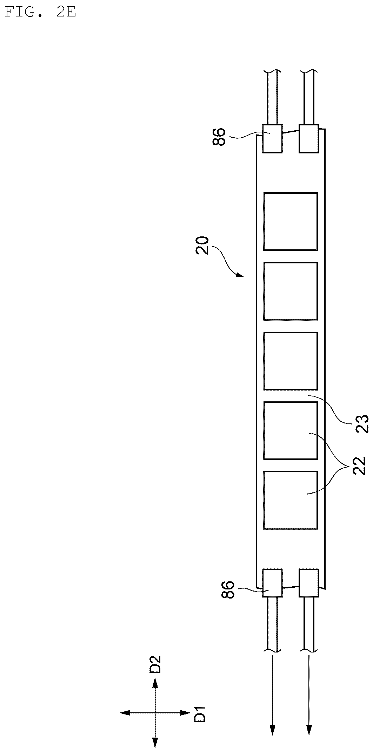

Finally, FIG. 2E shows an outlined view immediately before providing the metal mask 20 on the frame 15 under tension. When provided on the frame 15 under tension, tension in the longitudinal direction D2 is applied to the metal mask 20 with a clamp 86 or the like as shown in FIG. 2E. The metal mask 20 is thereby provided on the frame 15 under tension in a flat state. However, as the metal masks 20 differ in shape to a greater degree, tension adjustment needs to be performed more finely for each of the metal masks 20 to ensure hole positional accuracy. Consequently, even if the elongated metal plate 100 has a wavy shape, it is preferable that variation in the wavy shape should be reduced.

Thus, the present disclosure defines that when the differential expansion rate En is measured at each of an arbitrary plurality of positions of the elongated metal plate 100 in the longitudinal direction D2, a difference in the differential expansion rate En in the central portion in the width direction is 9.0 × 10⁻⁶ or less at a plurality of positions (the region Sk).

The differential expansion rates En at the arbitrary positions n in the width direction D1 thereby have equivalent values in a wide range of the elongated metal plate 100 in the longitudinal direction D2, and from whichever positions of the elongated metal plate 100 the metal masks 20 are cut out, the difference in shape decreases, so that uniformity in quality is improved. Therefore, variation in quality of the metal masks 20 obtained can be reduced.

In the present disclosure, "the difference in the differential expansion rate En" means a difference between the minimum value and the maximum value of the differential expansion rate En at the same position n in the differential expansion rate profiles measured at different positions, as shown in FIG. 1G. Moreover, the expression that "the difference in the differential expansion rate En is 9.0 × 10⁻⁶ or less" means that the difference in the differential expansion rate En is 9.0 × 10⁻⁶ or less at any of the positions n in the width direction D1. Furthermore, "an arbitrary plurality of positions in the longitudinal direction D2" refer to a plurality of positions selected at random in the longitudinal direction D2 of the elongated metal plate 100, and measuring the differential expansion rate profiles all over the elongated metal plate 100 may be included.

As an example, the number of selected positions at this time may be determined depending on the length of the elongated metal plate 100, and may be six spots (1 spot/100 m) or more when the length of the elongated metal plate 100 is 600 m, for example.

From such a perspective, the number of selected positions preferably may be 0.1 spot/100 m or more, may be 0.3 spot/100 m or more, may be 0.5 spot/100 m or more, may be 0.7 spot/100 m or more, may be 1 spot/100 m or more, may be 2 spots/100 m or more, may be 3 spots/100 m or more, may be 4 spots/100 m or more, may be 5 spots/100 m or more, or may be 10 spots/100 m or more for the length of the elongated metal plate 100.

Moreover, the number of selected positions preferably may be 100 spots/100 m or less, may be 90 spots/100 m or less, may be 80 spots/100 m or less, may be 70 spots/100 m or less, may be 60 spots/100 m or less, may be 50 spots/100 m or less, may be 40 spots/100 m or less, may be 30 spots/100 m or less, or may be 20 spots/100 m or less for the length of the elongated metal plate 100.

The number of selected positions may be determined by a combination of an arbitrary one of the above-described plurality of lower-limit candidate values and an arbitrary one of the above-described plurality of upper-limit candidate values. As such an example, the range of the number of selected positions preferably may be 0.1 spot/100 m or more and 100 spots/100 m or less, may be 0.3 spot/100 m or more and 90 spots/100 m or less, may be 0.5 spot/100 m or more and 80 spots/100 m or less, may be 0.7 spot/100 m or more and 70 spots/100 m or less, may be 1 spot/100 m or more and 60 spots/100 m or less, may be 2 spots/100 m or more and 50 spots/100 m or less, may be 3 spots/100 m or more and 40 spots/100 m or less, may be 4 spots/100 m or more and 30 spots/100 m or less, or may be 5 spots/100 m or more and 20 spots/100 m or less.

The difference in the differential expansion rate En in the central portion 140 in the width direction may be 9.0 × 10⁻⁶ or less, may be 8.0 × 10⁻⁶ or less, may be 7.0 × 10⁻⁶ or less, may be 6.0 × 10⁻⁶ or less, may be 5.0 × 10⁻⁶ or less, may be 4.0 × 10⁻⁶ or less, or may be 3.0 × 10⁻⁶ or less.

The lower limit of the difference in the differential expansion rate En in the central portion 140 in the width direction is not particularly restricted, and the smaller the lower limit, the more preferable it is. As an example, the difference in the differential expansion rate En may be 0 or more, may be 1.0 × 10⁻⁸ or more, may be 2.5 × 10⁻⁸ or more, may be 5.0 × 10⁻⁸ or more, may be 7.5 × 10⁻⁸ or more, may be 1.0 × 10⁻⁷ or more, may be 2.5 × 10⁻⁷ or more, or may be 5.0 × 10⁻⁷ or more.

The range of the difference in the differential expansion rate En in the central portion 140 in the width direction may be determined by a combination of an arbitrary one of the above-described plurality of lower-limit candidate values and an arbitrary one of the above-described plurality of upper-limit candidate values. As such an example, the range of the difference in the differential expansion rate En in the central portion preferably may be 0 or more and 9.0 × 10⁻⁶ or less, may be 1.0 × 10⁻⁸ or more and 8.0 × 10⁻⁶ or less, may be 2.5 × 10⁻⁸ or more and 7.0 × 10⁻⁶ or less, may be 5.0 × 10⁻⁸ or more and 6.0 × 10⁻⁶ or less, may be 7.5 × 10⁻⁸ or more and 5.0 × 10⁻⁶ or less, or may be 1.0 × 10⁻⁷ or more and 4.0 × 10⁻⁶ or less.

When the difference in the differential expansion rate En in the central portion 140 in the width direction falls within the above-described ranges, a tendency that the central portion 140 which is particularly likely to be used for manufacturing the metal masks 20 can be further improved in homogeneity in the longitudinal direction D2 is brought about.

The maximum value of the differential expansion rate En in the central portion 140 in the width direction preferably may be 2.5 × 10⁻⁵ or less, may be 2.0 × 10⁻⁵ or less, may be 1.5 × 10⁻⁵ or less, or may be 1.0 × 10⁻⁵ or less at a plurality of positions in the longitudinal direction D2 of the elongated metal plate 100. Note that a position at which the differential expansion rate En is maximized in the central portion 140 in the width direction is not particularly restricted, and as an example, may be positioned at the point a (0 mm [0%]) or a boundary (±200 mm [±40%]) between the central portion 140 and the side portion 150 in the example shown in FIG. 1G.

Note that "the maximum value of the differential expansion rate En" described above means a value which is maximum among the differential expansion rates En in the central portion 140 at each of a plurality of positions in the longitudinal direction D2 of the elongated metal plate 100. For example, the expression that "the maximum value of the differential expansion rate En is 2.5 × 10⁻⁵ or less" means that a value which is maximum among the differential expansion rates En in the central portion 140 at the plurality of positions in the longitudinal direction D2 of the elongated metal plate 100 is 2.5 × 10⁻⁵ or less. In other words, in such a case where the maximum value of the differential expansion rate En is 0.10% in the central portion 140 at a certain position in the longitudinal direction D2 of the elongated metal plate 100 and 1.2% at another position, it is expressed that "the maximum value of the differential expansion rate En is 2.5 × 10⁻⁵ or less".

The lower limit of the maximum value of the differential expansion rate En in the central portion 140 in the width direction is not particularly restricted, and the smaller the lower limit, the more preferable it is. As an example, the differential expansion rate En may be 0 or more, may be 1.0 × 10⁻⁸ or more, may be 2.5 × 10⁻⁸ or more, may be 5.0 × 10⁻⁸ or more, may be 7.5 × 10⁻⁸ or more, may be 1.0 × 10⁻⁷ or more, may be 2.5 × 10⁻⁷ or more, or may be 5.0 × 10⁻⁷ or more.

The range of the maximum value of the differential expansion rate En in the central portion 140 in the width direction may be determined by a combination of an arbitrary one of the above-described plurality of lower-limit candidate values and an arbitrary one of the above-described plurality of upper-limit candidate values. As such an example, the maximum value of the differential expansion rate En in the central portion 140 in the width direction preferably may be 0 or more and 2.5 × 10⁻⁵ or less, may be 1.0 × 10⁻⁸ or more and 2.0 × 10⁻⁵ or less, may be 2.5 × 10⁻⁸ or more and 1.5 × 10⁻⁵ or less, may be 5.0 × 10⁻⁸ or more and 1.0 × 10⁻⁵ or less, or may be 7.5 × 10⁻⁸ or more and 1.0 × 10⁻⁵ or less.

Note that the differential expansion rate En of the present disclosure is obtained by measuring the elongated metal plate 100 without being cut as will be described below in detail with reference to a measurement device. In other words, the differential expansion rate En of the present disclosure is the differential expansion rate En in the elongated metal plate 100, rather than a differential expansion rate of the metal plate after being cut. Consequently, if the differential expansion rate in another portion of the elongated metal plate 100 before being cut is unknown even if the differential expansion rate in the central portion of a certain metal plate obtained by cutting the elongated metal plate 100 is 2.5 × 10⁻⁵ or less, for example, a presumption that the maximum value of the differential expansion rate En is 2.5 × 10⁻⁵ or less does not hold when the elongated metal plate 100 is seen as a whole.

Next, a method for measuring the differential expansion rates En at an arbitrary plurality of positions in the longitudinal direction will be described. First, a conventional measurement device for a wavy shape of a metal plate is to measure, in a sheet form, a measurement sample (the metal plate 100k) cut out from the elongated metal plate 100. Therefore, the wavy shape of the elongated metal plate 100 cannot be evaluated in a wide range.

Moreover, in a case where the etching process through use of the photolithography technology is performed on a roll of the elongated metal plate 100, cutting out a measurement sample from an intermediate portion of the roll of the elongated metal plate 100 disconnects the roll itself, which significantly affects the etching process. Therefore, in this case, a measurement sample is cut out from a leading end of the roll of the elongated metal plate 100. Consequently, the wavy shape in a wide range including the intermediate portion of the roll of the elongated metal plate 100 cannot be evaluated with the conventional sheet-form measurement device.

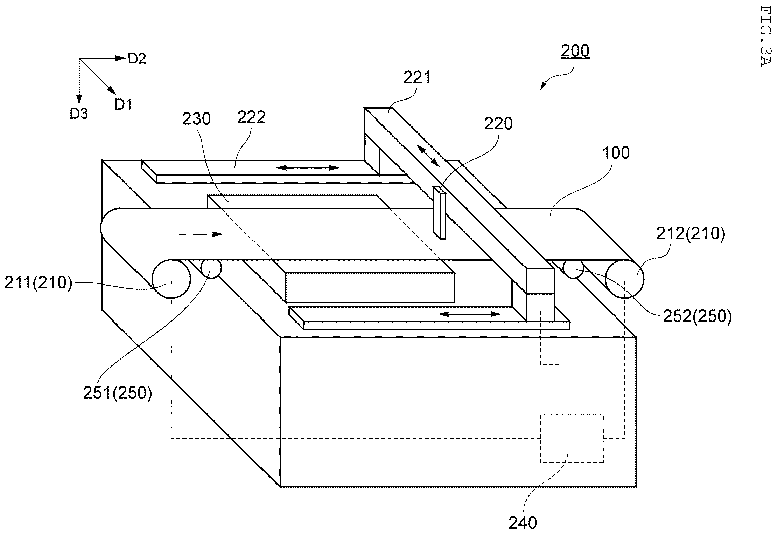

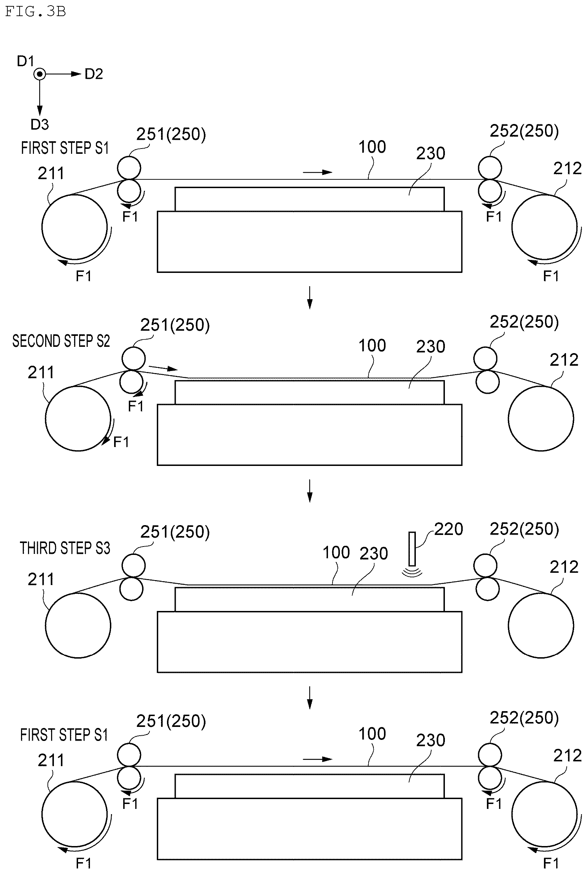

For solution of this point, description will be given while showing a perspective view representing an example of a measurement device for the elongated metal plate 100 of the present disclosure in FIG. 3A and showing steps of the method for measuring the elongated metal plate 100 in FIG. 3B. A measurement device 200 for the metal plate of the present disclosure includes a transfer mechanism 210 that transfers the elongated metal plate 100 in the longitudinal direction D2, a sensor 220 that measures the surface shape of the first surface 110 of the elongated metal plate 100, a stage 230 with which the second surface 120 positioned opposite to the first surface 110 of the elongated metal plate 100 comes into contact during measurement with the sensor 220, and a control unit 240.

The control unit 240 controls a tension adjustment mechanism 250, a lifting and lowering mechanism (not shown), and the like which will be described later in addition to the transfer mechanism 210 and the sensor 220, thereby repeatedly executing a first step S1, a second step S2, and a third step S3.

Although details of the steps will be described later, the elongated metal plate 100 is transferred by the transfer mechanism 210 in the first step S1 in a state where the elongated metal plate 100 is not in contact with the stage 230. In the second step S2, transfer of the elongated metal plate 100 is stopped, and the second surface 120 of the elongated metal plate 100, transfer of which is stopped, is brought into contact with the stage 230. In the third step S3, the surface shape of the first surface 110 of the elongated metal plate 100 is measured by the sensor 220 in the state where the second surface 120 of the elongated metal plate 100 is in contact with the stage 230. This enables the surface shape of the metal plate to be continuously measured in a wider range.

The transfer mechanism 210 transfers the elongated metal plate 100 in the longitudinal direction D2. The transfer mechanism 210 may have, for example, a first roll 211 that feeds the elongated metal plate 100 and a second roll 212 that rolls up the elongated metal plate 100. By feeding the elongated metal plate 100 from the first roll 211 and rolling up the elongated metal plate 100 into the second roll 212 in response to instructions from the control unit 240, the transfer mechanism 210 can transfer the elongated metal plate 100 in the longitudinal direction D2 and stop transfer of the elongated metal plate 100.

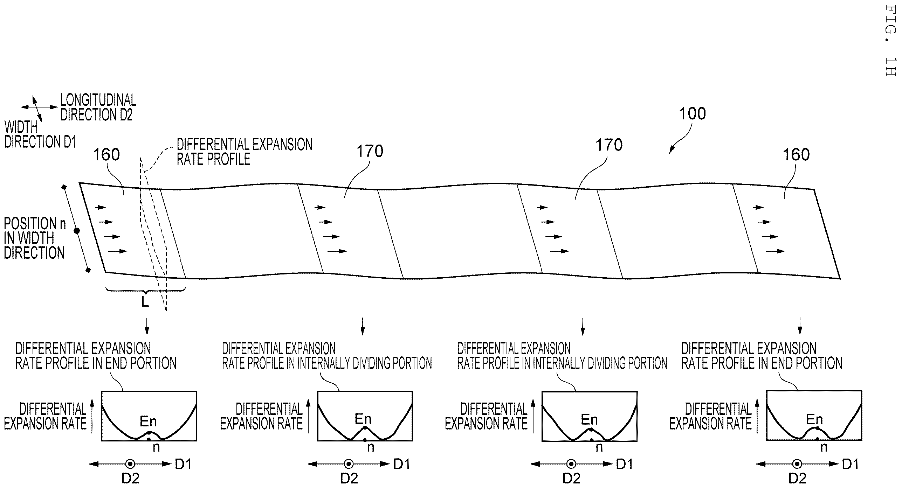

The transfer mechanism 210 may have a first supplementary roll 251 and a second supplementary roll 252 between the first roll 211 and the second roll 212. The first supplementary roll 251 and the second supplementary roll 252 may support the elongated metal plate 100 and perform transfer assistance for feeding and rolling up the elongated metal plate 100 between the first roll 211 and the second roll 212. The transfer mechanism 210 not only has the rolls shown in FIG. 1, but may also have another roll that contributes to transfer.

The sensor 220 measures the surface shape of the first surface 110 of the elongated metal plate 100. A surface state measured by the sensor 220 may include information concerning the height of the surface of the first surface 110 of the elongated metal plate 100. The information concerning the height is also referred to as a "height profile". This height profile may be data that three-dimensionally represents the surface shape of the first surface 110 of the elongated metal plate 100 and may include, for example, each position on the plane formed by the width direction D1 and the longitudinal direction D2 of the elongated metal plate 100 and information concerning the height of the surface of the elongated metal plate 100 in a height direction D3 for each position in association with each other.

The wavy shape on the surface of the first surface 110 can be represented by the height profile thus acquired with the sensor 220. The differential expansion rate in the width direction D1, the longitudinal direction D2, or another arbitrary direction, or the like can be calculated based on such a height profile. In other words, from the height profile at an arbitrary position, the differential expansion rate profile at that position can be obtained.

The sensor 220 is not particularly restricted as long as the surface shape of the first surface 110 of the elongated metal plate 100 can be measured, and example thereof can include an optical displacement sensor and a pressure displacement sensor. The height profile can be measured by measuring the distance between the sensor 220 and the first surface 110.

As the optical displacement sensor, a conventionally known one can be used. An example thereof can be a triangulation displacement sensor that irradiates a target object with light different in focus position depending on the wavelength to measure the height of the target object in accordance with an image forming position of reflected light of the light with which the target object is irradiated, a white light coaxial confocal displacement sensor that detects a wavelength position of a maximum light amount from a received spectrum to measure the height of the target object, or the like.

At least one of the sensor 220 and the stage 230 may be configured to be movable relative to each other. A device configuration shown in FIG. 3A, the stage 230 remains at rest, and the sensor 220 is configured to be movable relative to the stage 230. Specifically, the sensor 220 may be configured to be movable in the width direction D1 by means of the first moving mechanism 221. The first moving mechanism 221 may be configured to be movable in the longitudinal direction D2 by means of the second moving mechanism 222. This enables the sensor 220 to move also on the plane formed by the width direction D1 and the longitudinal direction D2. At this time, the first moving mechanism 221 and the second moving mechanism 222 may have mechanisms that acquire coordinates in the width direction D1 and the longitudinal direction D2, respectively. Accordingly, when information concerning the height is measured by the sensor 220, the value of the height and coordinates on the plane formed by the width direction D1 and the longitudinal direction D2 may be recorded in association with each other. The mechanisms that acquire the coordinates can include, for example, but are not particularly limited to, an encoder and a laser interferometer. In addition, the first moving mechanism 221 may be configured to be able to move the sensor 220 in the height direction D3. The sensor 220 is thereby movable also in the height direction D3 in addition to the planar direction. Note that instead of this, the sensor 220 may be fixed, and the stage 230 may be configured to be movable in the height direction D3.

By moving the stage 230 in the width direction D1 and the longitudinal direction D2, information concerning the height of the surface of the first surface 110 of the elongated metal plate 100 may be measured while moving the sensor 220 and the elongated metal plate 100 relatively in the width direction D1 and the longitudinal direction D2. On this occasion, the transfer mechanism may also be moved relatively in addition to the stage 230. In this case, the measurement device 200 may have a mechanism that controls driving of the stage 230 while acquiring coordinates in the width direction D1 and the longitudinal direction D2. The coordinates in the directions D1 and D2 at a position where the height has been measured by the sensor 220 may thereby be recorded. Herein, the mechanism that acquires the coordinates can include, for example, but is not particularly limited to, an encoder and a laser interferometer.

As described above, the planar coordinates in the width direction D1 and the longitudinal direction D2 and the information concerning the height of the elongated metal plate 100 at each coordinate position can be measured while relatively moving the sensor 220 and the stage 230, and can be recorded in association with each other. Then, by repeating measurement in a predetermined region of the elongated metal plate 100 on the stage 230 at regular intervals and intermittently moving the elongated metal plate 100 to repeat measurement in the length direction of the elongated metal plate 100, a three-dimensional profile which is the surface shape can be obtained over arbitrary positions of the elongated metal plate 100.

The control unit 240 repeatedly executes the first step S1, the second step S2, and the third step S3. FIG. 3B shows an aspect of a flow of the first step S1, the second step S2, and the third step S3. FIG. 3B is an outlined cross-sectional view on a plane formed by the longitudinal direction D2 and the height direction D3.

As shown in FIG. 3B, in the first step S1, the control unit 240 controls driving of the transfer mechanism 210 so as to transfer the elongated metal plate 100 in the state where the elongated metal plate 100 is not in contact with the stage 230. Specifically, the control unit 240 rotates, in a feed direction F1, the first roll 211 that feeds the elongated metal plate 100 and the second roll 212 that rolls up the elongated metal plate 100. The elongated metal plate 100 is thereby transferred in the longitudinal direction D2.

As shown in FIG. 3B, the control unit 240 may rotate, in the feed direction F1, the first supplementary roll 251 and the second supplementary roll 252 that assist transfer of the elongated metal plate 100. Note that in the example shown in FIG. 3B, the first supplementary roll 251 and the second supplementary roll 252 are rolls constituting the transfer mechanism 210 and are also rolls constituting the tension adjustment mechanism 250 which will be described later.

In the first step S1, the control unit 240 may exert control to adjust tension to be applied to the elongated metal plate 100 between the first roll 211 and the second roll 212 by controlling a rotating speed of the first roll 211 and the second roll 212, thereby keeping the elongated metal plate 100 from coming into contact with the stage 230 due to bending.

In the second step S2, the control unit 240 stops transfer of the elongated metal plate 100 by means of the transfer mechanism 210 and brings the second surface 120 of the elongated metal plate 100, transfer of which is stopped, into contact with the stage 230. Specifically, after stopping transfer of the elongated metal plate 100, the control unit 240 may reduce tension on the elongated metal plate 100 by means of the tension adjustment mechanism 250 which will be described later to bend the elongated metal plate 100, so that the bent elongated metal plate 100 comes into contact with the stage 230.

Instead of this or in addition to this, the elongated metal plate 100 and the stage 230 may be relatively moved up/down in the height direction D3 by means of the lifting and lowering mechanism (not shown) such that the bent elongated metal plate 100 comes into contact with the stage 230.

In the third step S3, the surface shape of the first surface 110 of the elongated metal plate 100 is measured by the sensor 220 in the state where the second surface 120 of the elongated metal plate 100 is in contact with the stage 230. Specifically, the control unit 240 may control driving of the first moving mechanism 221 and the second moving mechanism 222 to move the sensor 220 to an arbitrary position in the plane formed by the longitudinal direction D2 and the width direction D1. The sensor 220 may measure the height of the elongated metal plate 100 at each place on the plane formed by the longitudinal direction D2 and the width direction D1 along with the movement, thereby obtaining the height profile.

Next, a hardware configuration of the control unit 240 will be described. The control unit 240 may be implemented by a microcontroller (MCU) or may be implemented by a general-purpose computer further including an input device such as a keyboard and an output device such as a display. In the case where the control unit 240 is a microcontroller, an information input/output device may be connected to an input/output interface of the microcontroller.

In particular, the control unit 240 may be electrically connected to the transfer mechanism 210, the sensor 220, the first moving mechanism 221, the second moving mechanism 222, the tension adjustment mechanism 250, and the lifting and lowering mechanism (not shown). For clearly expressing the diagram, FIG. 3A is expressed with components except connections with the control unit 240, the respective rolls constituting the transfer mechanism 210, the first moving mechanism 221, and the second moving mechanism 222 omitted. However, since the control unit 240 controls the measurement device 200, electrically-controlled constitutional mechanisms of the measurement device 200 may all be connected to the control unit 240 by wire or wirelessly even if there is no specific depiction. For example, although a connection between the sensor 220 and the control unit 240 is not expressed in the example of FIG. 3A, it can be construed that the sensor 220 and the control unit 240 are connected with the first moving mechanism 221 and the second moving mechanism 222 interposed therebetween.

The measurement device 200 of the present disclosure may further have the tension adjustment mechanism 250. The tension adjustment mechanism 250 is not particularly restricted as long as it adjusts tension in the longitudinal direction D2 on the elongated metal plate 100. At this time, in the first step S1, the control unit 240 may adjust the tension on the elongated metal plate 100 by means of the tension adjustment mechanism 250 such that the elongated metal plate 100 does not come into contact with the stage 230, thereby transferring the elongated metal plate 100 by means of the transfer mechanism 210. Alternatively, the control unit 240 may stop transfer of the elongated metal plate 100 and adjust the tension on the elongated metal plate 100 by means of the tension adjustment mechanism 250 such that the elongated metal plate 100 comes into contact with the stage 230.

FIG. 3A and FIG. 3B show an aspect of using the first supplementary roll 251 and the second supplementary roll 252 as an aspect of the tension adjustment mechanism 250. In the second step S2, the control unit 240 stops transfer of the elongated metal plate 100 by means of the transfer mechanism 210 and brings the second surface 120 of the elongated metal plate 100, transfer of which is stopped, into contact with the stage 230.

At this time, in the aspect shown in FIG. 3B, the control unit 240 slightly rotates the first roll 211 and the first supplementary roll 251 of the tension adjustment mechanism 250 in the feed direction F1 and stops them after stopping the transfer mechanism 210. On this occasion, the control unit 240 fixes the second supplementary roll 252 so as not to rotate. The elongated metal plate 100 between the first supplementary roll 251 and the second supplementary roll 252 is thereby bent by a length fed by the first supplementary roll 251. The second surface 120 of the bent elongated metal plate 100 comes into contact with the stage 230.

Subsequently, the method for measuring the elongated metal plate 100 will be described. The method for measuring the elongated metal plate 100 of the present disclosure repeatedly executes the first step S1, the second step S2, and the third step S3 using the above-described measurement device. This enables the surface shape of the metal plate to be continuously measured in a wider range. Since it is unnecessary to measure a measurement sample cut from the metal plate in the sheet form unlike the conventional device, the influence of distortion of the metal plate caused by cutting can be eliminated.

Note that hereinafter, an operation of repeating transfer and stop of the elongated metal plate 100 will also be referred to as an intermittent operation.

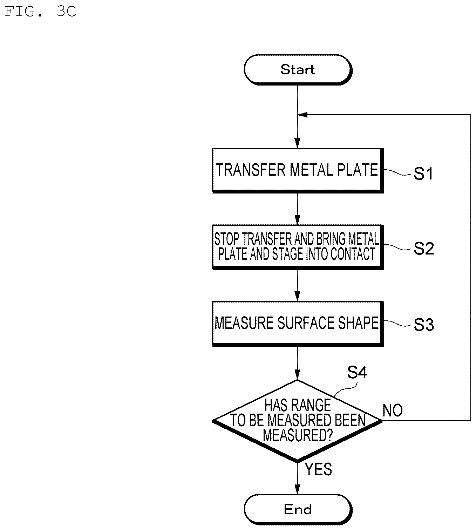

FIG. 3C shows a flowchart representing an aspect of the method for measuring the metal plate. As shown in FIG. 3C, in the method for measuring the metal plate of the present disclosure, the elongated metal plate 100 is transferred by the transfer mechanism 210 in the first step S1 in the state where the elongated metal plate 100 is not in contact with the stage 230.

At this time, the transfer mechanism 210 may execute the intermittent operation of transferring the elongated metal plate 100 in the longitudinal direction D2 by a distance of one stage 230 or less. The surface shape in a range continuous in the longitudinal direction D2 can thereby be measured.

Alternatively, the transfer mechanism 210 may execute the intermittent operation of transferring the elongated metal plate 100 in the longitudinal direction D2 by a distance larger than one stage 230. The surface shape in a range not continuous in the longitudinal direction D2 can thereby be measured. For example, the surface shape of the elongated metal plate 100 can be measured every 5 m by executing the intermittent operation of repeating transfer and stop every 5 m.

In the method for measuring the metal plate of the present disclosure, in the second step S2, transfer of the elongated metal plate 100 is stopped, and the second surface 120 of the elongated metal plate 100, transfer of which is stopped, is brought into contact with the stage 230.

At this time, the second surface 120 of the elongated metal plate 100 is brought into contact with the stage 230 using the tension adjustment mechanism 250 and the lifting and lowering mechanism (not shown) as described above. In the present disclosure, it is preferable to measure the surface shape in a state where no tension is applied to the elongated metal plate 100. This can eliminate the influence on the measurement of the surface shape caused by the tension applied by the transfer mechanism 210. Therefore, in the second step S2, it is preferable to bring the second surface 120 of the elongated metal plate 100 in the bent state into contact with the stage 230. The elongated metal plate 100 with the second surface brought into contact with the stage 230 is not bent on the stage 230 and may be bent between the first supplementary roll 251 and the stage 230 and between the second supplementary roll 252 and the stage 230.

In the third step S3, the surface shape of the first surface 110 of the elongated metal plate 100 is measured by the sensor 220 in the state where the second surface 120 of the elongated metal plate 100 is in contact with the stage 230. Measurement pitches in the longitudinal direction D2 and the width direction D1 are not particularly limited and can be determined as appropriate depending on a desired measurement accuracy, and each may be set at approximately 1 to 50 mm, for example.

Note that although the measurement of the surface shape of the first surface 110 of the elongated metal plate 100 has been described above, the surface shape of the second surface 120 can naturally be measured if the surface of a measurement target is inverted.

In the fourth step S4, the control unit 240 confirms whether a preset range has been measured, and when measurement of the preset range has been finished, terminates the measuring operation. When the measurement of the preset range has not been finished, the first step S1 to the third step S3 may further be repeated.

Next, a method for manufacturing the metal plate of the present disclosure will be described. The method for manufacturing the metal plate of the present disclosure is a method for manufacturing the metal plate having the above-described difference in the differential expansion rate En, includes the rolling step of rolling a base material to obtain the elongated metal plate 100, and may include a slitting step of cutting both ends of the elongated metal plate 100 and an annealing step of heat-treating the elongated metal plate 100 according to necessity.

The rolling step is a step of rolling a base material 55 to obtain the elongated metal plate 100. A rolling method can include, for example, but is not particularly limited to, a rolling method through use of a pair of rolling rolls 56a, 56b that roll the base material 55 in the thickness direction. The base material 55 can include, for example, but is not particularly limited to, an iron alloy containing nickel.

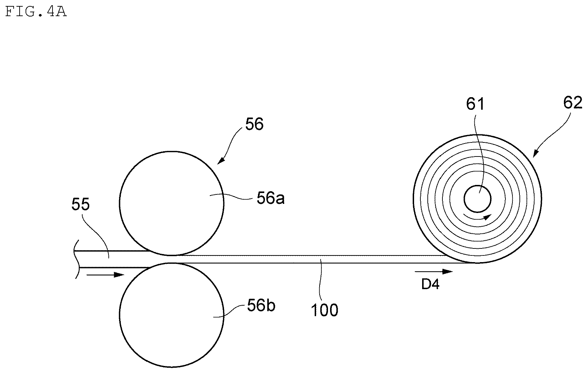

FIG. 4A shows an outlined cross-sectional view of the rolling step. First, the base material 55 is transferred to the rolling rolls 56a, 56b in a direction D4. The base material 55 is rolled by the pair of rolling rolls 56a, 56b. As a result, the base material 55 is reduced in thickness and extended in the transfer direction. The elongated metal plate 100 is thereby obtained. The elongated metal plate 100 may be rolled up around a core 61 to form a rolled body 62.

Note that FIG. 4A merely shows an outline of the rolling step, and a specific configuration and procedure for carrying out the rolling step are not particularly limited. For example, the rolling step may include a hot-rolling step of processing the base material at a temperature of or above a recrystallization temperature of the invar material constituting the base material 55 or a cold-rolling step of processing the base material at a temperature of or below the recrystallization temperature of the invar material. FIG. 4A illustrates transferring the base material 55 in the right direction of the sheet of drawing, the transfer direction of the base material at the time of rolling is not limited to this, and the base material 55 may be transferred in the left direction of the sheet of drawing. Alternatively, the base material 55 may be transferred to reciprocate to right and left between the rolling rolls 56a, 56b and may be rolled in that process.

In the rolling step, the base material 55 may be rolled to a desired thickness at one time, or may be rolled to a desired thickness by carrying out the rolling step a plurality of times at a predetermined rolling rate. During rolling, a rolling oil or the like may be used according to necessity.

From the viewpoint of adjusting the differential expansion rate En, the difference in the differential expansion rate En in the overall width direction, the difference in the differential expansion rate En in the central portion 140 in the width direction, and the like at an arbitrary plurality of positions in the longitudinal direction of the elongated metal plate 100 of the present disclosure, uniformity of the pressing force fluctuation and uniformity of a pressing force distribution may be adjusted.

From the viewpoint of obtaining the elongated metal plate 100 with the wavy shape reduced, it is preferable that the pressing force should be constant without fluctuating. However, the base material partially has a hard metal tissue or partially has a large thickness in some cases. Therefore, a pressing force applied to the rolls that roll the base material fluctuates along with the passage of the base material. In order to reduce such a fluctuation in the pressing force, a method such as increasing the number of rolls or providing an adjustment mechanism for keeping the pressing force constant can be used. This keeps uniformity of the pressing force fluctuation, which leads to the tendency that the wavy shape is reduced.

From the viewpoint of obtaining the elongated metal plate 100 with the wavy shape reduced, it is preferable that the pressing force applied to the base material by the rolls should be uniform in the width direction to prevent the pressing force from differing depending on the place where the rolls and the base material come into contact. However, the base material partially has a hard metal tissue or partially has a large thickness in some cases. Therefore, the pressing force applied to the rolls that roll the base material may become nonuniform in the width direction. In order to reduce such nonuniformity of the pressing force, a method such as providing an adjustment mechanism for keeping the pressing force constant at both ends of the roll can be used. This keeps uniformity of the pressing force distribution, which leads to the tendency that the wavy shape is reduced.

In the rolling step, a control system that performs shape analysis of the metal plate at the time of rolling and in accordance with a result of the analysis, controls a pressing force and a pressing position on the metal plate by work rolls may be used. Note that various control parameters may be set by one of ordinary skill in the art according to necessity. For example, the shape of the metal plate may be detected in real time and in accordance with the shape, the offset amount of the work rolls may be adjusted to be an amount that a tolerance of the surface shape of the plate falls within a predetermined range, thereby reducing waviness at the time of rolling to make the shape more uniform. Note that the offset amount of the work rolls refers to an amount of shift of the work rolls positioned on and under the metal plate to be rolled from the central position. For example, plate warping can be controlled by shifting the work rolls positioned on and under the metal plate, and the shape of the metal plate may thereby be cancelled out.

Moreover, in order to further improve the accuracy of this shape uniformization control, a thickness sensor may be increased in accuracy from a viewpoint of improving the accuracy of real-time detection of the shape of the metal plate. Furthermore, a plurality of points where the thickness is to be measured may be provided in the width direction, and thickness measurement may be performed not only in the central portion but also in the side portions to control the pressing force and pressing position in accordance with information about the thickness measurement. In addition, a plate speed sensor may be increased in accuracy since it is necessary to roll a specific portion of the metal plate running in a certain direction by the work rolls at a predetermined offset amount.

The slitting step is a step of cutting both ends of the elongated metal plate 100. This can eliminate cracks that may be caused by rolling at both the ends of the elongated metal plate 100. By carrying out such a slitting step, breakage of the elongated metal plate 100 occurring from a crack, what is called plate cracking, can be reduced. The slitting step may include cutting off both the ends in the width direction of the elongated metal plate 100, respectively, in a predetermined range, thereby adjusting the width of the elongated metal plate 100 to be a desired width.

For example, the elongated metal plate 100 having a total width exceeding 500 mm, for example, a total width of 700 mm may be produced by rolling the base material 55, and thereafter, both the ends in the width direction of the elongated metal plate 100 may be cut to produce the elongated metal plate 100 having the width of 500 mm. At this time, both the ends of the elongated metal plate 100 may be cut equally by 100 mm or may be cut unequally such that a cut width becomes 200 mm in total.

For example, in a case where there is a region having a comparatively large differential expansion rate on one end side of the elongated metal plate 100, the one end side of the elongated metal plate 100 having a total width of 700 mm may be cut wider than the other end side. In a case where a region having a comparatively small differential expansion rate exists with a shift from the center of the elongated metal plate 100 to the one end side, both the ends may be cut such that the portion having a small differential expansion rate becomes the central portion 140 of the elongated metal plate 100 having a width of 700 mm after the slitting step.

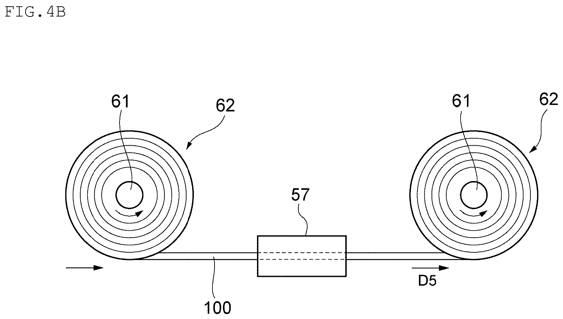

The annealing step is a step of heat-treating the elongated metal plate 100. A residual stress (internal stress) accumulated in the elongated metal plate 100 due to rolling is thereby removed. A heat-treating method is not particularly limited, and as shown in FIG. 4B, for example, the elongated metal plate 100 may be heat-treated using an annealing device 57 in a process of transferring the elongated metal plate 100 in a direction D5 in a roll-to-roll process. On that occasion, heat treatment may be executed while pulling the elongated metal plate 100 in the transfer direction (the longitudinal direction D2). Alternatively, heat treatment may be executed in a batch process in a state where the elongated metal plate 100 has been rolled up around the core 61.

The annealing step may be carried out in a non-reducing atmosphere or an inert gas atmosphere. Herein, the non-reducing atmosphere refers to an atmosphere substantially not containing a reducing gas such as hydrogen. The expression "substantially not containing a reducing gas" means that the concentration of the reducing gas such as hydrogen is 4% or less. The inert gas atmosphere refers to an atmosphere in which an inert gas such as argon gas, helium gas, or nitrogen gas is present by 90% or more. Carrying out the annealing step in the non-reducing atmosphere or the inert gas atmosphere can prevent nickel hydroxide or the like from being produced in the first surface 110 or the second surface 120 of the elongated metal plate 100.

Treatment conditions of the annealing step can be set as appropriate in accordance with the thickness, rolling rate, and the like of the elongated metal plate 100. For example, the treatment conditions of the annealing step may be set at 500°C and 60 seconds.

The rolling step, the slitting step, and the annealing step may be repeated a plurality of times. At that time, these steps may be performed in random order. The method for manufacturing the metal plate of the present disclosure leads to the tendency that the elongated metal plate 100 having a high homogeneity in a wider range can be obtained.

The metal mask of the present disclosure will be described. Note that in the present specification and the present drawings, an example of a metal mask to be used when manufacturing an organic EL display device, and a method for manufacturing the metal mask will be described as one embodiment of the present invention unless otherwise specified.

The metal mask 20 of the present disclosure has the perforated region 22 and a peripheral region 23. The perforated region 22 is a region in which the plurality of through-holes 25 have been formed. The peripheral region 23 is a region positioned around the perforated region 22.

FIG. 5A shows a plan view of the metal mask 20 of one embodiment of the present disclosure on the second surface 20b side. As shown in FIG. 5A, the metal mask 20 may have a generally rectangular contour in plan view. Note that "plan view" in the present disclosure refers to seeing the metal mask 20 from a plane along a plate surface of the metal mask 20.

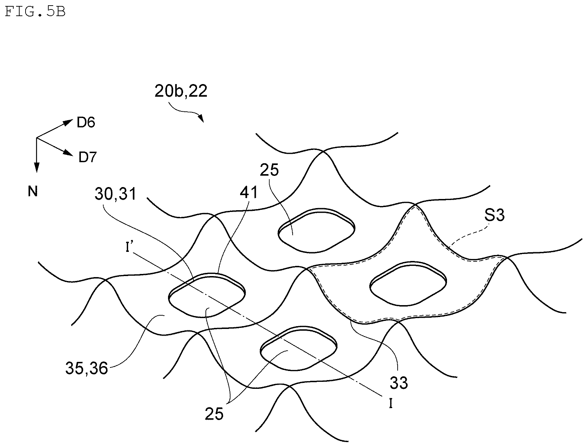

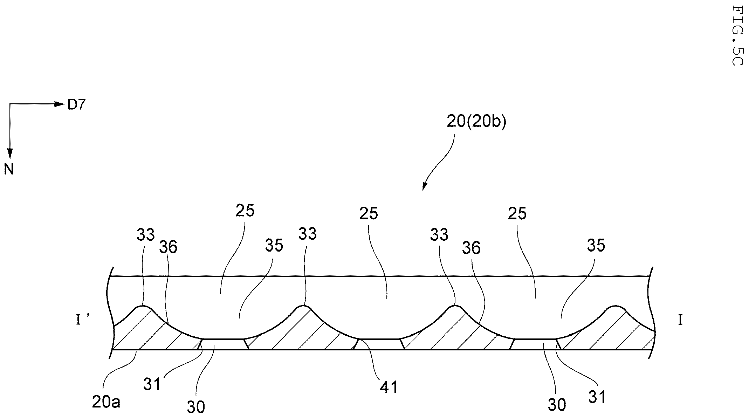

FIG. 5B shows an example of a perspective view of the perforated region 22 as seen from the second surface 20b side. FIG. 5C shows a cross-sectional view of a cross-section I-I shown in FIG. 5B. FIG. 5B and FIG. 5C show an example in which the second wall surfaces 36 of the second recesses 35 of adjacent ones of the through-holes 25 join in the second surface 20b.

As shown in FIG. 5B and FIG. 5C, the through-hole 25 has the first recess 30 formed in the first surface 20a, the second recess 35 formed in the second surface 20b, and a surrounding connecting portion 41 that connects the first recess 30 and the second recess 35. The through-hole 25 is formed by the first recesses 30 on the first surface 20a side and the second recess 35 on the second surface 20b side communicating with each other. A portion where the first recess 30 and the second recess 35 communicate with each other is the connecting portion 41. A first wall surface 31 of the first recess 30 and the second wall surface 36 of the second recess 35 are connected with the surrounding connecting portion 41 interposed therebetween.

An area of the first recess 30 in plan view may gradually decrease from the first surface 20a toward the second surface 20b. An area of the second recess 35 in plan view may gradually decrease from the second surface 20b toward the first surface 20a. The first recess 30 may be configured as a recess smaller in diameter than the second recess 35.

At the connecting portion 41, a direction in which a wall surface of the through-hole 25 spreads changes discontinuously. In general, an opening area of the through-hole 25 in plan view is minimized at the connecting portion 41.

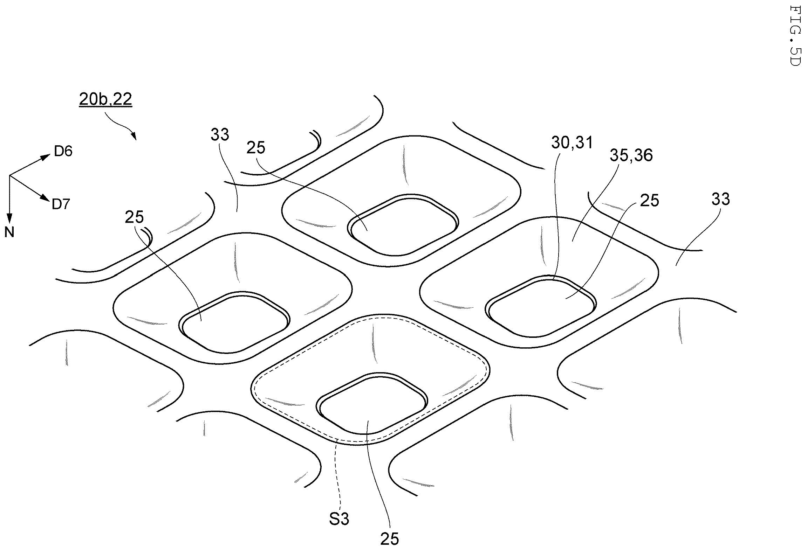

FIG. 5D shows another example of a perspective view of the perforated region 22 as seen from the second surface 20b side. FIG. 5D is an example in which the second wall surfaces 36 of the second recesses 35 of adjacent ones of the through-holes 25 do not join in the second surface 20b.

The metal mask 20 of the present disclosure has the first surface 20a and the second surface 20b as front and rear surfaces. In the present disclosure, the first surface 20a and the second surface 20b of the metal mask 20 are distinguished depending on the diameter of the through-hole 25 in the front and rear surfaces in the perforated region 22. Specifically, as shown in FIG. 5D, the first surface 20a refers to a surface in which the opening area of the through-hole 25 is small in the perforated region 22, and the second surface 20b refers to a surface in which a range S3 of the through-hole 25 is large. In the case where the second wall surfaces 36 of the second recesses 35 of adjacent ones of the through-holes 25 join in the second surface 20b as shown in FIG. 5B, FIG. 5C, and the like, the range S3 closed by a ridge portion 33 surrounding one through-hole 25 may be regarded as the opening of the through-hole 25. In this case, the range closed by the ridge portion 33 is an opening area.

From the viewpoint of the vapor deposition step, the first surface 20a may be a surface of the metal mask 20 that faces the substrate 92 in a case where the metal mask device 10 is stored in a vapor deposition device 90 (see FIG. 8). The second surface 20b may be a surface of the metal mask 20 that is positioned on a crucible 94 side that holds the vapor deposition material 98 in the case where the metal mask device 10 is stored in the vapor deposition device 90 (see FIG. 8).

In the metal mask 20 of the present disclosure, one perforated region 22 may be configured to correspond to one organic EL display device. As shown in FIG. 5A, for example, the metal mask 20 may have a plurality of the perforated regions 22 arranged in line at predetermined intervals in a longitudinal direction D7. The metal mask 20 may also have the perforated regions 22 in a plurality of lines in a width direction D6. In FIG. 5A, the peripheral region 23 is positioned around each of the perforated regions 22. The use of the metal mask 20 enables a plurality of organic EL display devices to be vapor-deposited on the substrate 92 which will be described later.

The perforated regions 22 of the metal mask 20 may have the total pitch marks 28. The total pitch marks 28 are marks provided for evaluating the positional accuracy among the plurality of through-holes 25 in the metal mask 20, and the like.

For example, the total pitch mark 28 may be arranged in the vicinity of a corner of each of the perforated regions 22 and outside the perforated region 22 (in other words, the peripheral region 23), or may be arranged on the inner side of the perforated region 22. The total pitch mark 28 may be formed in a recessed manner at a desired position of the first surface 20a or the second surface 20b by half-etching in a first surface etching step or a second surface etching step which will be described later. Alternatively, a through-hole extending from the first surface 20a to the second surface 20b may be formed and used as the total pitch mark 28. Although FIG. 5A shows an example in which the total pitch mark 28 has a circular planar shape, the total pitch mark is not limited to this and may have an arbitrary shape such as a rectangle.

Note that a "distance TP" shown in FIG. 5A is a distance between the total pitch marks 28 and is a distance between both ends of the perforated regions 22 aligned in the longitudinal direction D7.

The metal mask 20 of the present disclosure is obtained by the method for manufacturing the metal mask according to one embodiment of the present disclosure as will be described later and thus has a tendency that the positional accuracy and dimensional accuracy of the through-holes 25 are favorable.

Subsequently, the method for manufacturing the metal mask according to one embodiment of the present disclosure will be described.

The method for manufacturing the metal mask according to one embodiment of the present disclosure includes a preparation step of preparing the elongated metal plate 100 having the first surface 110 and the second surface 120 positioned opposite to the first surface 110, and an etching step of etching the elongated metal plate 100 to form the above-described metal mask 20. The above-described elongated metal plate 100 is used as the elongated metal plate 100.

Note that although a method for manufacturing the metal mask 20 by etching will be described below, the metal mask 20 may be formed by either etching or laser machining.

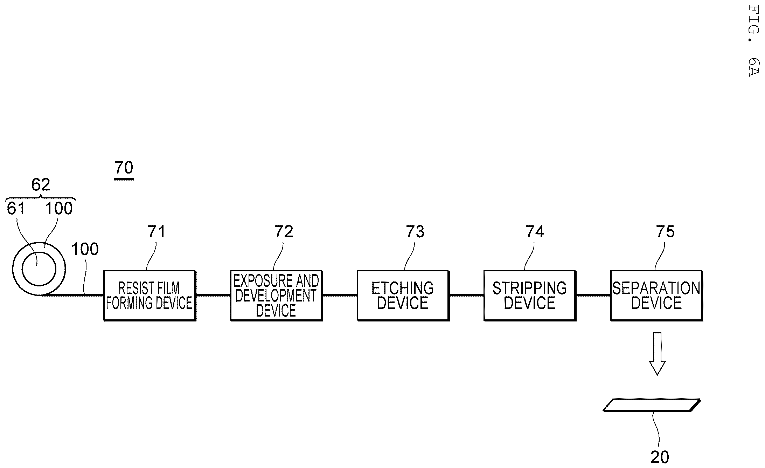

The method for manufacturing the metal mask 20 according to one embodiment of the present disclosure will be described mainly with reference to FIG. 6A to FIG. 6F. FIG. 6A is an outlined view showing a manufacturing apparatus 70 for manufacturing the metal mask 20 using the elongated metal plate 100 together with its processing order. FIG. 6A shows an example in which the elongated metal plate 100 is supplied continuously from a resist film forming device 71 to a stripping device 74. However, the method for manufacturing the metal mask 20 of the present disclosure is not limited to this, and, for example, the elongated metal plate 100 may be rolled up each time it undergoes processing by each of the devices to be brought into a state of a rolled-up body. When the elongated metal plate 100 is supplied to each of the devices, the elongated metal plate 100 may be pulled out from the rolled-up body and supplied.

Hereinafter, each step of the method for manufacturing the metal mask 20 will be described in detail.

First, the elongated metal plate 100 having a desired thickness is prepared (the preparation step). The elongated metal plate 100 may be in the state of a rolled body 62 wound around the core 61. The method for fabricating the elongated metal plate 100 having a desired thickness can include, for example, but is not particularly limited to, the above-described rolling method, a plating deposition method, or the like.

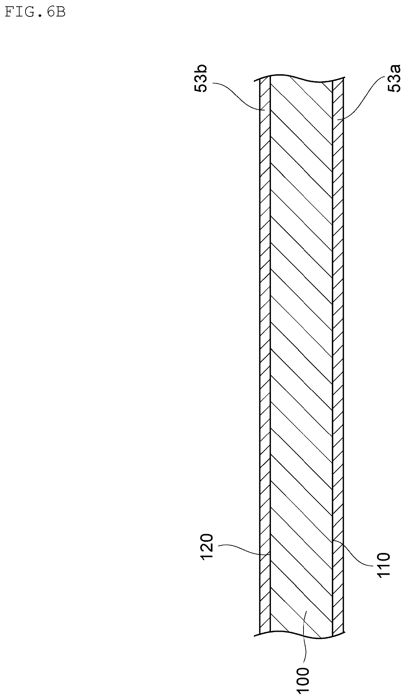

Subsequently, the resist films 53a and 53b are formed on the first surface 110 and the second surface 120 of the elongated metal plate 100 using the resist film forming device 71 (FIG. 6B). Specifically, the resist films 53a and 53b may be formed by bonding a dry film resist to the first surface 110 and the second surface 120. Alternatively, the resist films 53a and 53b may be formed by coating the first surface 110 and the second surface 120 with a coating liquid containing a photosensitive resist material and drying the first surface 110 and the second surface 120.

The dry film resist and the coating liquid are not particularly limited, and conventionally known ones can be used. The resist films 53a and 53b thus formed may be either a negative type resist or a positive type resist. Between them, the negative type resist is preferably used.

The thickness of the resist films 53a and 53b preferably may be 15 µm or less, may be 10 µm or less, may be 6 µm or less, or may be 4 µm or less. The thickness of the resist films 53a and 53b preferably may be 1 µm or more, may be 3 µm or more, may be 5 µm or more, or may be 7 µm or more. The range of the thickness of the resist films 53a and 53b may be determined by a combination of an arbitrary one of the above-described plurality of upper-limit candidate values and an arbitrary one of the above-described plurality of lower-limit candidate values.

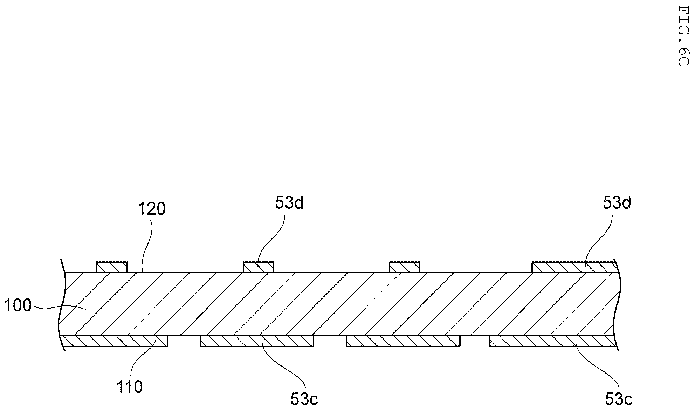

Subsequently, the resist films 53a and 53b are exposed and developed using an exposure and development device 72. This enables a first resist pattern 53c to be formed on the first surface 110 and a second resist pattern 53d to be formed on the second surface 120 as shown in FIG. 6C. In the case where a negative type resist film is used, for example, a photomask configured so as not to let light pass through a to-be-removed region of the resist film may be arranged on the resist film, so that the resist film may be exposed through the photomask, and the resist film may further be developed.

Subsequently, an etching device 73 is used to etch the elongated metal plate 100 using the first resist pattern 53c and the second resist pattern 53d as masks (the etching step). The etching step may include the first surface etching step and the second surface etching step.

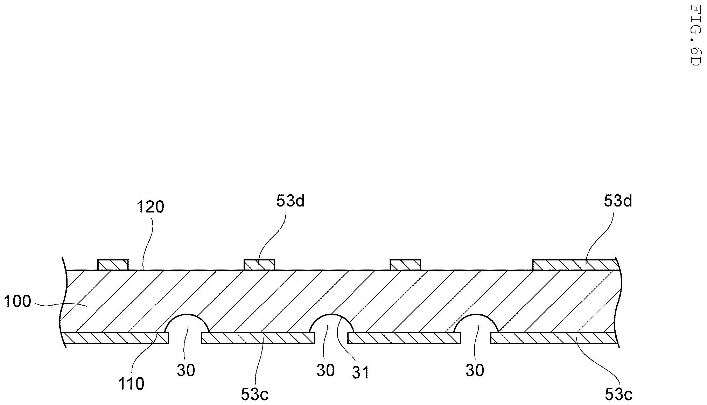

FIG. 6D shows an outlined view representing an example of the first surface etching step in the perforated region 22. In the first surface etching step, regions of the first surface 110 which are not covered by the first resist pattern 53c are etched using an etching solution. On this occasion, the second surface 120 may be covered by resin or the like resistant to the etching solution.

Erosion by the etching solution progresses in the regions of the first surface 110 which are not covered by the first resist pattern 53c (FIG. 6D). A large number of the first recesses 30 are thereby formed in the first surface 110. Note that etching of the elongated metal plate 100 may progress isotropically in various directions from holes of the resist pattern. Thus, the first recess 30 and the second recess 35 are shaped such that their cross sectional areas at each position in the thickness direction of the metal mask 20 gradually decrease with progress in the thickness direction from the surfaces.

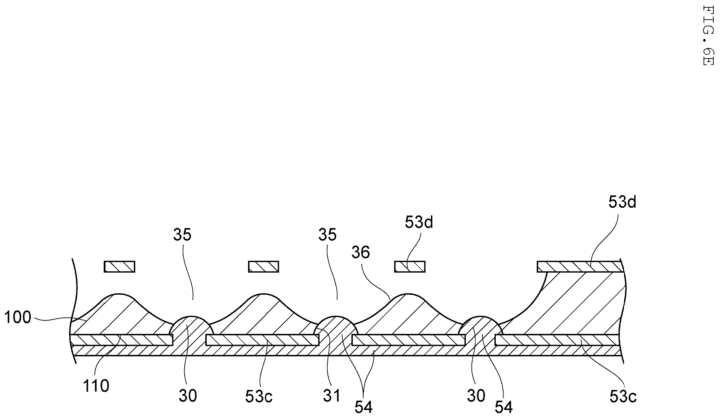

FIG. 6E shows an outlined view representing an example of the second surface etching step in the perforated region 22. In the second surface etching step, the regions of the second surface 120 which are not covered by the second resist pattern 53d are etched using the etching solution. On this occasion, the film or the like covering the second surface 120 in the first surface etching step may be stripped in advance. The first surface 110 may be covered by a resin 54 or the like resistant to the etching solution.

Erosion by the etching solution progresses in the regions of the second surface 120 which are not covered by the second resist pattern 53d (FIG. 6E). The second recesses 35 are thereby formed in the second surface 120. The first recess 30 and the second recess 35 then communicate with each other, thereby forming the through-hole 25.

The etching solution is not particularly limited as long as it is conventionally known, and examples thereof can include a solution containing a ferric chloride solution and hydrochloric acid.

In the second surface etching step, etching may progress until adjacent ones of the second recesses 35 are connected to each other as shown in FIG. 6E. At a location where adjacent ones of the second recesses 35 are connected to each other, the adjacent ones of the second recesses 35 join to form the ridge portion 33. The ridge portion 33 is spaced from the second resist pattern 53d, and erosion by etching also progresses in the thickness direction of the elongated metal plate 100 at a top of the ridge portion 33. The second resist pattern 53d is thereby stripped from the elongated metal plate 100. Note that the second surface 120 may be partially left between adjacent ones of the second recesses 35.

Furthermore, the resist patterns and the resin 54 or the like resistant to the etching solution are stripped from the elongated metal plate 100 using the stripping device 74. Then, a separation step of cutting the elongated metal plate 100 using a separation device 75, thereby separating the metal mask 20 formed of a sheet-like metal plate from the elongated metal plate 100 is performed. The metal mask 20 can be obtained in this manner.

According to such a method for manufacturing the metal mask 20, the use of the above-described metal plate 100 leads to a tendency that a metal mask excellent in positional accuracy and dimensional accuracy of the through-holes can be obtained.

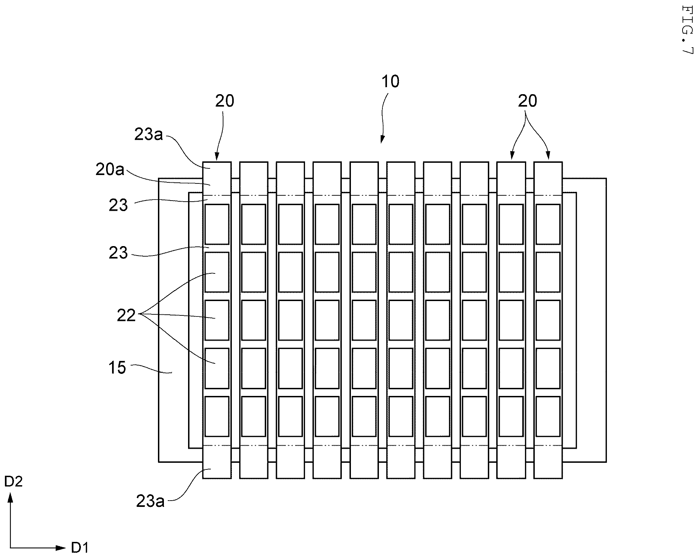

The metal mask device 10 according to one embodiment of the present disclosure includes the frame 15 and the above-described metal mask 20 installed on the frame 15. The metal mask 20 may be installed on the frame 15 with the second surface 20b in contact with the frame 15. FIG. 7 shows a plan view of the metal mask device 10 as seen from the first surface 20a side of the metal mask 20. FIG. 8 shows a cross-sectional view representing the vapor deposition device.

In the metal mask device 10 of the present disclosure, a plurality of the metal masks 20 may be attached to one frame (FIG. 7). In this case, the plurality of metal masks 20 may be aligned in the width direction D1 crossing the longitudinal direction D2 of the metal mask 20. Each of the metal masks 20 may be fixed to the frame 15 at both end portions 23a in the longitudinal direction D2 of the metal mask 20.

A method for fixing the metal masks 20 to the frame 15 can include, for example, but is not particularly limited to, welding and the like.

The metal mask device 10 may include a member fixed to the frame 15 and partially overlapped on the metal masks 20 in the thickness direction of the metal masks 20. Such a member can include, for example, but is not particularly limited to, a member extending in the direction crossing the longitudinal direction of the metal masks 20 and supporting the metal masks 20, a member overlapped on a gap between adjacent two metal masks, and the like.

Next, a method for manufacturing an organic EL display device using the metal mask 20 according to the present disclosure will be described with reference to FIG. 8. The organic EL display device may include, in a stacked state, the substrate 92 and a vapor deposition layer including the vapor deposition material 98 provided in a pattern shape.

The method for manufacturing the organic EL display device of one embodiment of the present disclosure can include, for example, but is not particularly limited to, a vapor deposition step of vapor-depositing the vapor deposition material 98 on a substrate such as the substrate 92 using the metal mask 20.

In the vapor deposition step, the metal mask device 10 is arranged first such that the metal mask 20 is opposed to the substrate 92. On this occasion, the first surface 20a of the metal mask 20 may be opposed to the substrate 92 as shown in FIG. 8. Herein, the substrate 92 is an evaporation target such as a glass substrate.

In a case where the metal mask device 10 is stored in the vapor deposition device 90 as shown in FIG. 8, a surface of the metal mask 20 facing the substrate 92 is the first surface 20a, and a surface of the metal mask 20 positioned on the crucible 94 side that holds the vapor deposition material 98 is the second surface 20b. In the vapor deposition device 90, the metal mask 20 is located on a surface of the substrate 92 on the crucible 94 side. Herein, the metal mask 20 and the substrate 92 may be brought into close contact with each other by a magnetic force.

In the vapor deposition device 90, the crucible 94 that stores the vapor deposition material 98 and a heater 96 that heats the crucible 94 may be arranged below the metal mask device 10. Herein, the vapor deposition material 98 may be an organic light emitting material as an example. The vapor deposition material 98 in the crucible 94 is vaporized or sublimated by heating of the heater 96. The vaporized or sublimated vapor deposition material 98 adheres to the substrate 92 by way of the through-holes 25 of the metal mask 20. The vapor deposition material 98 is thereby deposited on the surface of the substrate 92 in a desired pattern corresponding to the position of the through-holes 25 of the metal mask 20. Note that in the vapor deposition step, the inside of the vapor deposition device 90 may be brought into a vacuum atmosphere.

In a case of intending to vapor-deposit different types of vapor deposition materials in accordance with pixels such as RGB, the vapor deposition material 98 may be deposited on the surface of the substrate 92 using different metal masks 20 in accordance with colors of the vapor deposition material 98. For example, the vapor deposition material 98 for red, the vapor deposition material 98 for green, and the vapor deposition material 98 for blue may be sequentially deposited on the substrate 92. Alternatively, the metal mask 20 (the metal mask device 10) and the substrate 92 may be relatively moved little by little in an array direction (the aforementioned one direction) of the through-holes 25 to sequentially deposit the vapor deposition material 98 for red, the vapor deposition material 98 for green, and the vapor deposition material 98 for blue.

The method for manufacturing the organic EL display device may include various steps in addition to the vapor deposition step of vapor-depositing the vapor deposition material 98 on the substrate such as the substrate 92 using the metal mask 20. For example, the method for manufacturing the organic EL display device may include a step of forming a first electrode on the substrate. The vapor deposition layer is formed on the first electrode. The method for manufacturing the organic EL display device may also include a step of forming a second electrode on the vapor deposition layer. The method for manufacturing the organic EL display device may also include a sealing step of sealing the first electrode, the vapor deposition layer, and the second electrode provided on the substrate 92.

The vapor deposition layer formed on the substrate such as the substrate 92 using the metal mask 20 is not limited to the light emitting layer formed by vapor deposition of the above-described organic light emitting material, and may include other layers. For example, the vapor deposition layer may include a hole injection layer, a hole transport layer, a light emitting layer, an electron transport layer, an electron injection layer, and the like in this order from the first electrode side. In this case, the vapor deposition step through use of the metal mask 20 corresponding to each of the layers may be performed.

According to the method for manufacturing the organic EL display device of the present disclosure, the use of the above-described metal mask 20 leads to the tendency that an organic EL display device excellent in dimensional accuracy and positional accuracy of pixels can be obtained.

Note that the above-described embodiment can be modified variously. Hereinafter, modifications will be described with reference to the drawings according to necessity. In the following description and the drawings used in the following description, a portion that may be configured similarly to the above-described embodiment is denoted by a reference character identical to the reference character used for a corresponding portion in the above-described embodiment, and repeated description is omitted. In a case where the action and effect obtained in the above-described embodiment are clearly obtained also in the modifications, the description thereof is omitted in some cases.

As a modification, FIG. 1H shows a perspective view representing another example of the elongated metal plate 100 of the present disclosure. The elongated metal plate 100 of the modification is such that when the differential expansion rate En is measured at specific positions in the longitudinal direction D2, the difference in the differential expansion rate En is 9.0 × 10⁻⁶ or less.

In other words, the aspect shown in FIG. 1A and the aspect shown in FIG. 1H are different from each other in that the former measures the differential expansion rate En at arbitrary positions in the longitudinal direction D2, while positions at which the differential expansion rate En is measured are specified in the latter, and are common in terms of the remaining configuration. Specific positions in the longitudinal direction D2 in the modification include both end portions 160 in the longitudinal direction of the elongated metal plate 100 and portions 170 that internally divide the elongated metal plate 100 in the longitudinal direction D2 into one or more portions.

FIG. 1H shows an aspect in which the two portions 170 internally divide the elongated metal plate 100 in the longitudinal direction D2 into three portions. For example, when the elongated metal plate 100 shown in FIG. 1H has a total length of 600 m, the differential expansion rate En is measured for places of 0 m, 200 m, 400 m, and 600 m assuming that one end is located at 0 m.

The unit length L0 is a certain measurement range having a width of 1280 mm, for example. The expression that "the differential expansion rate En is measured at specific positions in the longitudinal direction D2" indicates that positions of 0 m, 200 m, 400 m, and 600 m, for example, should only be included in this measurement range. For example, if a range from one end to 200 m ± 0.64 m is measured, it can be said that the differential expansion rate En is measured at the position of 200 m from the one end. If a range from the one end to 0 m to 1.28 m or from the one end to 598.72 m to 600 m is measured, it can be said that the differential expansion rate En is measured at the position of 0 m or 600 m from the one end.

The portions 170 are positioned such that the elongated metal plate 100 is internally divided equally in the longitudinal direction D2 into one or more portions. The number of the portions 170 may be determined depending on the length of the elongated metal plate 100.

The number of the portions 170 can be similar to the above-described number of selected positions and may be, for example, 1 spot/100 m or more and 100 spots/100 m or less, may be 3 spots/100 m or more and 90 spots/100 m or less, may be 5 spots/100 m or more and 80 spots/100 m or less, may be 7 spots/100 m or more and 70 spots/100 m or less, may be 10 spots/100 m or more and 60 spots/100 m or less, may be 15 spots/100 m or more and 50 spots/100 m or less, or may be 20 spots/100 m or more and 40 spots/100 m or less.

Even such an elongated metal plate 100 has a high homogeneity in a wider range.

A method for manufacturing the metal plate according to the modification is similar to the foregoing, includes the rolling step of rolling a base material to obtain the elongated metal plate 100, and may include the slitting step of cutting both ends of the elongated metal plate 100 and the annealing step of heat-treating the elongated metal plate 100 according to necessity.

A method for manufacturing a metal mask according to the modification is also similar to the foregoing and includes the preparation step of preparing the elongated metal plate 100 having the first surface 110 and the second surface 120 positioned opposite to the first surface 110 and the etching step of etching the elongated metal plate 100, thereby forming the above-described metal mask 20.

### EXAMPLES

Hereinafter, the present invention will be described more specifically using examples and comparative examples. The present invention is not limited at all by the following examples.

### (First Rolled Body and First Sample)

First, the rolling step, the slitting step, and the annealing step described above were carried out on a base material made of an invar material to manufacture a plurality of rolled bodies obtained by rolling up elongated metal plates.

Specifically, a first rolling step of performing a first hot-rolling step and a first cold-rolling step in this order was carried out first. Next, a first slitting step of cutting off both ends in the width direction of the elongated metal plate, respectively, in a range of 3 to 5 mm was carried out. Thereafter, a first annealing step of continuously annealing the elongated metal plate at 500°C for 60 seconds was carried out.

Furthermore, a second rolling step including a second cold-rolling step was carried out on the elongated metal plate undergone the first annealing step. Next, a second slitting step of cutting off both ends in the width direction of the elongated metal plate, respectively, in a range of 3 to 5 mm was carried out. Thereafter, a second annealing step of continuously annealing the elongated metal plate at 500°C for 60 seconds was carried out.

The elongated metal plate 100 having a desired thickness and a width of 600 mm was thereby obtained. Thereafter, a slitting step of cutting off both the ends in the width direction of the elongated metal plate 100, respectively, in a predetermined range, thereby finally adjusting the width of the elongated metal plate 100 to a desired width, specifically, a width of 500 mm was carried out.

Note that the cold-rolling step was performed using a rolling oil while cooling the elongated metal plate 100. After the cold-rolling step, a cleaning step of cleaning the elongated metal plate with a hydrocarbon-based cleaning agent was performed. After the cleaning step, the slitting step, the annealing step, and the slitting step described above were carried out. Thereafter, a leading end part of the rolled body was cut off to obtain a first sample made of an elongated metal plate having a width of 500 mm and a length of 600 m.

Next, a height position of a surface of the first sample was measured continuously by the apparatus and method shown in FIG. 3A to FIG. 3C to acquire a height profile of the elongated metal plate 100. Then, a profile of the differential expansion rate En in the unit length L0 in the longitudinal direction for the arbitrary position n in the width direction of the metal plate was obtained based on the height profile. Note that a measurement interval of the height profile was set at a 2-mm interval in the width direction D1 and a 10-mm interval in the longitudinal direction D2.

Note that the unit length L0 was set at 1280 mm. The measurement of the differential expansion rate En was performed in a range of 0 m to 1.28 m, and a range of 200 m ± 0.64 m, a range of 400 m ± 0.64 m, and a range of 598.72 m to 600 m from one end. Note that, for this unit length L0 (1280 m), a metal mask of a larger product size is assumed.

### (Second Rolled Body to Fifth Rolled Body and Second Sample to Fifth Sample)

Similarly to the case of the first rolled body, a second rolled body to a fifth rolled body were manufactured from a base material made of an invar material. Furthermore, for the second rolled body to the fifth rolled body, the differential expansion rate of a sample taken out from each of the rolled bodies was measured similarly to the case of the first rolled body.

Note that for the second rolled body, pressure adjustment was performed such that the pressing force to be applied to the central portion of the metal plate in accordance with the passage of the base material did not fluctuate comparatively in the hot-rolling step and cold-rolling step described above.

For the third rolled body, pressure adjustment was performed such that fluctuation in the pressing force to be applied to the central portion of the metal plate in accordance with the passage of the base material was reduced as compared with that when the second rolled body was manufactured. The thickness of the central portion of the metal plate was detected in real time, and the offset amount and direction of the work rolls positioned on and under the metal plate were adjusted in accordance with the thickness.

For the fourth rolled body, pressure adjustment was performed such that fluctuation in the pressing force to be applied to the central portion of the metal plate in accordance with the passage of the base material was reduced similarly to that when the second rolled body was manufactured, and furthermore, the pressing force to be applied to the base material was made comparatively uniform in the width direction. In other words, pressure adjustment was performed such that fluctuation in the pressing force to be applied not only to the central portion of the metal plate but also to the side portions was reduced.

For the fifth rolled body, pressure adjustment was performed such that fluctuation in the pressing force to be applied to the central portion of the metal plate in accordance with the passage of the base material was reduced similarly to that when the second rolled body was manufactured, and furthermore, uniformity in the width direction of the pressing force to be applied to the base material was improved as compared with that when the fourth rolled body was manufactured. Pressure adjustment was thereby performed such that fluctuation in the pressing force to be applied not only to the central portion of the metal plate but also to the side portions was reduced. At this time, the thicknesses of the central portion and the side portions of the metal plate were detected in real time, and the offset amount and direction of the work rolls positioned on and under the metal plate were adjusted in accordance with the thicknesses.

Note that by reducing fluctuation in the pressing force in accordance with the passage of the base material as compared with that when the second rolled body was manufactured, the differential expansion rate in the central portion was able to be reduced to be small as a whole in manufacturing of the third rolled body, and the differential expansion rate in the central portion had a small maximum value. However, in the third rolled body thus obtained, the difference in the differential expansion rate En in the overall width direction was larger than that of the second rolled body whereas the differential expansion rate in the central portion was reduced to be small as a whole.

This reveals that the difference in the differential expansion rate En in the overall width direction does not simply become small by performing the operation of reducing the differential expansion rate to be small as a whole. A reason for this is considered because even if fluctuation in the pressing force is made uniform, the difference in the differential expansion rate En in the overall width direction might be large due to variation in thickness of the base material since the thickness the base material originally has also fluctuates microscopically. However, the reason is not limited to this.

Note that as described above, the comparison between the second rolled body and the third rolled body led to a result that the third rolled body had a larger difference in the differential expansion rate En in the overall width direction than the second rolled body. However, the comparison between the second rolled body and the third rolled body does not indicate that reduction in fluctuation in the pressing force does not contribute to a decrease in the difference in the differential expansion rate En. That the reduction in fluctuation in the pressing force contributes to the decrease in the difference in the differential expansion rate En is apparent from the comparison between the first rolled body and the second rolled body.

### (Metal Mask)

The metal mask 20 was produced from each of the elongated metal plates 100 of the first rolled body to the fifth rolled body using the above-described method for manufacturing the metal mask. In other words, the through-holes 25 were formed, and the metal mask 20 was obtained. Here, the metal mask 20 whose dimension in the width direction D1 was 67 mm and in which the distance between both the ends of the perforated regions 22 aligned in the longitudinal direction D2 was 1280 mm was produced. For hundred metal masks 20 obtained from different locations in the longitudinal direction D2 of the first rolled body to the fifth rolled body, a total pitch (TP) which was the distance between the total pitch marks 28 as shown in FIG. 5A was calculated, and a standard deviation thereof was calculated. Then, variation (3σ) in the total pitch was calculated.

Table 1 shows the maximum value of the difference in the differential expansion rate En at a plurality of positions in the roll of the elongated metal plate 100, the maximum value of the differential expansion rate in the central portion 140 in the roll of the elongated metal plate 100, and the variation (3σ).

**[Table 1]**

| | | Maximum value of differential expansion rate En in central portion | Difference in differential expansion rate En in central portion at a plurality of positions in longitudinal direction D2 | Variation (3σ) |
|---|---|---|---|---|
| Comparative Example 1 | First rolled body | 5.0×10⁻⁵ | 1.5×10⁻⁵ | 21.2 µm |
| Comparative Example 2 | Second rolled body | 3.6×10⁻⁵ | 1.2×10⁻⁵ | 18.5 µm |
| Comparative Example 3 | Third rolled body | 2.7×10⁻⁵ | 9.9×10⁻⁶ | 15.7 µm |
| Example 1 | Fourth rolled body | 2.2×10⁻⁵ | 8.0×10⁻⁶ | 11.2 µm |
| Example 2 | Fifth rolled body | 9.9×10⁻⁶ | 2.5×10⁻⁶ | 9.8 µm |

Note that the metal mask 20 in which the distance between both the ends of the perforated regions 22 aligned in the longitudinal direction D2 was set at 980 mm was also produced similarly to the foregoing, the total pitch (TP) which was the distance between the total pitch marks 28 was calculated, and a standard deviation thereof was calculated. Then, the variation (3σ) in the total pitch was calculated. At that time, the variation (3σ) in the total pitch of Comparative Example 1 was 12.5 µm. The unit length L0 of 980 mm is a length assuming a metal mask of a conventional product size. This reveals that in a case of assuming a metal mask (for example, the unit length L0 = 1280 mm) of a large-scale product size, the variation (3σ) became larger.

Moreover, metal plates were cut out arbitrarily from the rolled bodies and were measured. As a result, metal plates whose differential expansion rate had a large value and metal plates whose differential expansion rate had a small value were obtained from the rolled body of Comparative Example 1. Although metal plates whose differential expansion rate had a small value were partially obtained from the rolled body of Comparative Example 1 as described, the variation in the differential expansion rate was wide when the rolled body was seen as a whole, and homogeneity of products was not ensured. This reveals that even if the differential expansion rate is evaluated partially in a short region, variation in the differential expansion rate in the elongated metal plate cannot be evaluated, and homogeneity of products cannot be evaluated.

### Industrial Applicability

The present invention has industrial applicability as a metal plate which is elongated and is to be used for manufacturing a metal mask.

### Reference Signs List

10 metal mask device
15 frame
20 metal mask
20a first surface
20b second surface
22 perforated region
23 peripheral region
23a end portion
25 through-hole
27 outer shape
28 total pitch mark
30 first recess
31 first wall surface
33 ridge portion
35 second recess
36 second wall surface
41 connecting portion
53a resist film
53b resist film
53c first resist pattern
53d second resist pattern
54 resin
55 base material
56a rolling roll
56b rolling roll
57 annealing device
61 core
62 rolled body
70 manufacturing apparatus
71 resist film forming device
72 exposure and development device
73 etching device
74 stripping device
75 separation device
86 clamp
90 vapor deposition device
92 substrate
94 crucible
96 heater
98 vapor deposition material
100 elongated metal plate
100k metal plate
110 first surface
120 second surface
130 side edge
140 central portion
150 side portion
160 both end portions
170 portion
200 measurement device
210 transfer mechanism
211 first roll
212 second roll
220 sensor
221 first moving mechanism
222 second moving mechanism
230 stage
240 control unit
250 tension adjustment mechanism
251 first supplementary roll
252 second supplementary roll

## Claims

1. A metal plate which is elongated and is to be used for manufacturing a metal mask, wherein
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

2. A metal plate which is elongated and is to be used for manufacturing a metal mask, wherein
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

3. The metal plate according to claim 1 or 2, wherein a maximum value of the differential expansion rate En in the central portion in the width direction is 2.5 × 10⁻⁵ or less at the plurality of the positions.

4. The metal plate according to claim 1 or 2, wherein the metal plate has a roll shape.

5. The metal plate according to claim 1 or 2, wherein the metal plate has a length of 50 to 800 m in the longitudinal direction.

6. The metal plate according to claim 1 or 2, wherein the metal plate has a thickness of 50 µm or less.

7. A method for manufacturing a metal plate which is elongated and is to be used for manufacturing a metal mask, comprising
a rolling step of rolling a base material to obtain the metal plate which is elongated, wherein
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

8. A method for manufacturing a metal plate which is elongated and is to be used for manufacturing a metal mask, comprising
a rolling step of rolling a base material to obtain the metal plate which is elongated, wherein
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.

9. A method for manufacturing a metal mask, comprising:
a rolling step of rolling a base material to prepare a metal plate which is elongated; and
an etching step of etching the metal plate to form the metal mask, wherein
in the metal plate,
when a differential expansion rate En in a unit length L0 in a longitudinal direction for an arbitrary position n in a width direction of the metal plate is measured at each of an arbitrary plurality of positions in the longitudinal direction,
a difference in the differential expansion rate En in a central portion in the width direction is 9.0 × 10⁻⁶ or less at a plurality of the positions, and
the central portion is a portion that occupies 80% in the width direction of the metal plate excluding both side portions that occupy 10% in the width direction.

10. A method for manufacturing a metal mask, comprising:
a rolling step of rolling a base material to prepare a metal plate which is elongated; and
an etching step of etching the metal plate to form the metal mask, wherein
in the metal plate,
when a differential expansion rate En in a unit length L0 in a longitudinal direction for an arbitrary position n in a width direction of the metal plate is measured at each of a plurality of positions in the longitudinal direction,
a difference in the differential expansion rate En in a central portion in the width direction is 9.0 × 10⁻⁶ or less at a plurality of the positions,
the central portion is a portion that occupies 80% in the width direction of the metal plate excluding both side portions that occupy 10% in the width direction, and
the plurality of the positions include both end portions in the longitudinal direction of the metal plate and a portion that internally divides the metal plate in the longitudinal direction into one or more portions.
